# FASCICULE DE BREVET EUROPEEN

(11) **EP 4 657 773 B1**
(45) Date de publication et mention de la délivrance du brevet: **28.10.2026**
(21) Numéro de dépôt: 25208779.6
(22) Date de dépôt: 13.01.2023
(51) Int. Cl.: H01S 5/0687, H01S 5/00, H01S 5/40

(54) **PROCÉDÉ DE POSITIONNEMENT SPECTRAL D'UN SYSTÈME PHOTONIQUE, ET SYSTEME PHOTONIQUE METTANT EN OEUVRE UN TEL PROCÉDÉ**
VERFAHREN ZUR SPEKTRALEN POSITIONIERUNG EINES PHOTONISCHEN SYSTEMS UND PHOTONISCHES SYSTEM ZUR DURCHFÜHRUNG SOLCH EINES VERFAHRENS
METHOD FOR THE SPECTRAL POSITIONING OF A PHOTONIC SYSTEM AND PHOTONIC SYSTEM CARRYING OUT SUCH A METHOD

(30) Priorité: 24.05.2022 FR 2204950; 25.07.2022 FR 2207600
(43) Date de publication de la demande: 03.12.2025
(62) Numéro(s) de document de la (des) demande(s) initiale(s) en application de l'article 76 CBE: 23700295.1 / 4 533 608
(73) Titulaire: Scintil Photonics, 38000 Grenoble (FR)
(72) Inventeur: MENEZO, Sylvie, 38000 Grenoble (FR); ENAULT, Florian, 38000 Grenoble (FR)
(74) Mandataire: IP Trust

(56) Documents cités:
- WO-A1-2013/044863
- US-A1- 2002 043 616
- US-A1- 2004 066 807
- US-B1- 9 838 134

## Description

### DOMAINE DE L'INVENTION

L'invention concerne un système photonique. Plus précisément l'invention porte sur un procédé de positionnement spectral d'un dispositif photonique comprenant, au moins, une source laser et un filtre. Le filtre peut être un filtre en anneau résonnant, un filtre de type interféromètre de Mach Zehnder (MZ) ou former, en partie au moins, un modulateur en anneau résonnant ou un modulateur MZ.

### ARRIERE PLAN TECHNOLOGIQUE DE L'INVENTION

On connaît dans l'état de la technique de nombreuses méthodes visant à aligner entre eux la fréquence de résonance d'un filtre optique et la fréquence d'émission d'une source laser. L'ajustement de la fréquence de résonnance ou la fréquence d'émission peuvent être faits à l'aide d'un réchauffeur placé à proximité du filtre ou du laser. Le réchauffeur est commandé de manière à « verrouiller » le système, c'est-à-dire à faire correspondre la fréquence d'émission à la fréquence de résonnance.

Dans le document "Error-free operation of a polarization-insensitive 4λ; x 25 Gbps silicon photonic WDM receiver with closed-loop thermal stabilization of Si microrings," Opt. Express 24, 13204-13209 (2016) un photodétecteur et un réchauffeur sont associés à chaque filtre du système. Un régulateur mesure à intervalles réguliers le courant fourni par le photodétecteur et ajuste incrémentalement la commande du réchauffeur en vue de maximiser le courant produit, et ainsi chercher à aligner la fréquence d'émission du laser et la fréquence de résonnance du filtre. Chaque filtre (ou groupes de filtres) du système comprend sa propre boucle de régulation (incluant un réchauffeur et un photodétecteur) et est donc verrouillé individuellement.

Le document "Wavelength Locking and Thermally Stabilizing Microring Resonators Using Dithering Signals," in Journal of Lightwave Technology, vol. 32, no. 3, pp. 505-512, Feb.1, 2014 propose également un procédé de positionnement spectral d'un système photonique similaire, incluant une pluralité de filtres munis de réchauffeurs et de photodétecteurs. Selon l'approche divulguée par ce document, les fréquences de résonnances des filtres sont modulées à l'aide d'un signal de modulation en créneau. Pour chaque filtre, un circuit analogique effectue le produit entre le signal fourni par le photodétecteur et le signal de modulation, filtre les harmoniques pour ne conserver que la partie statique de ce produit pour identifier, selon le signe de cette partie statique, si la fréquence d'émission est inférieure ou supérieure à la fréquence de résonnance. Cette information est exploitée pour ajuster la commande appliquée au réchauffeur en vue de réduire l'écart existant entre ces deux fréquences.

Selon cette approche également chaque filtre du système photonique comprend sa propre boucle de régulation (incluant un réchauffeur et un photodétecteur) et est donc verrouillé individuellement.

Lorsque le système photonique présente plusieurs voies, c'est-à-dire plusieurs fréquences de résonnance et/ou plusieurs fréquences d'émission qu'il est nécessaire de verrouiller respectivement entre elles, ces méthodes nécessitent autant de photodétecteurs que de voies. La présence d'un photodétecteur pour chaque voie à verrouiller rend ces approches particulièrement complexes à mettre en œuvre, notamment lorsque le nombre de voies est important, par exemple supérieur 10 ou à 50. Par ailleurs, l'approche selon laquelle la fréquence de modulation s'applique au filtre et à sa fréquence de résonnance peut conduire à verrouiller plusieurs filtres sur une unique fréquence d'émission alors qu'il est généralement recherché de verrouiller chaque filtre sur une fréquence d'émission qui lui est propre afin de former des voies indépendantes.

Le document "Simultaneous wavelength locking of microring modulator array with a single monitoring signal," Opt. Express 25, 16040-16046 (2017) propose une technique permettant le verrouillage simultané des fréquences de résonnance d'un réseau de modulateurs en anneau sur les raies spectrales d'un rayonnement lumineux en peigne de fréquences. Comme cela est bien connu en soi, un modulateur en anneau permet à la fois de filtrer une longueur d'onde choisie parmi plusieurs longueurs d'onde et permet la modulation de cette longueur d'onde choisie. Dans le document précité, le verrouillage est réalisé à l'aide d'un unique photodétecteur prélevant la puissance du rayonnement circulant dans un bus optique auquel sont couplés les modulateurs et dans lequel circule un signal optique WDM modulé. Un algorithme d'optimisation exploite la partie RF de puissance optique du rayonnement, c'est-à-dire la puissance générée par les modulateurs, pour établir les signaux de commande de réchauffeurs respectivement associés à ces modulateurs, les commandes visant à maximiser la puissance optique RF présent dans le bus optique.

Lors de l'initialisation de l'algorithme d'optimisation, chaque modulateur est ajusté consécutivement au cours d'une recherche exhaustive jusqu'à ce qu'il y ait un gradient notable dans la puissance RF mesurée. À ce stade, une méthode de gradient prend le relais pour une convergence rapide vers le meilleur biais de chauffage. Pendant ce processus, chaque modulateur est verrouillé. Une fois le dernier modulateur en anneau ajusté, l'algorithme utilise la méthode du gradient sans fin sur chaque anneau pour assurer le suivi de la dérive de température. L'approche suivie par ce document repose sur l'hypothèse que la puissance optique RF est maximale lorsque les fréquences de résonnance des modulateurs sont bien alignées avec les fréquences d'émission formant les raies spectrales du rayonnement. Pour que cette hypothèse soit satisfaite, il est notamment essentiel que les données modulées par chaque modulateur soient non corrélées. Cette approche nécessite également que les fréquences d'émission soient bien séparées les unes des autres, de 50 GHz au moins pour éviter de verrouiller plusieurs modulateurs sur une unique fréquence d'émission.

Une autre approche se fondant sur un seul photodétecteur et sur la modulation des fréquences de résonnances des filtres est présentée dans le document « Streamlined Architecture for Thermal Control and Stabilization of Cascaded DWDM Micro-Ring Filters Bus » présenté par Maarten Hattink lors de la conférence Optical Fiber Conference, tenue du 6 au 10 mars 2022. Cette approche nécessite toutefois une calibration du dispositif qui rend la solution particulièrement lourde à exploiter. Le choix des fréquences de modulations proposé par ce document conduit à introduire des termes d'erreur sur le signal d'asservissement. Et à nouveau, cette configuration présente le risque de verrouiller plusieurs modulateurs sur une unique fréquence d'émission.

Le document WO 2013/044863 A1, qui est considéré comme représentant l'état de la technique le plus pertinent, décrit un procédé de positionnement spectral d'un système photonique, le système photonique comprenant en particulier un filtre présentant une fréquence de résonance, un photodétecteur pour recevoir un rayonnement filtre, le photodétecteur produisant un signal de contrôle, un dispositif d'ajustement commande pour moduler et ajuster une fréquence d'émission , un conditionnement du signal de contrôle conduisant à produire un signal numérique de contrôle avec une première opération de traitement du signal numérique de contrôle, une deuxième opération de traitement du premier signal de verrouillage pour produire une commande numérique d'ajustement, la deuxième opération visant à optimiser l'amplitude du premier signal de verrouillage.

### OBJET DE L'INVENTION

Un but de l'invention est de proposer un procédé de positionnement spectral d'un système photonique n'ayant pas les limitations de l'état de la technique et s'en distinguant. Plus précisément, un but de l'invention est de proposer un système de positionnement spectral ne nécessitant pas autant de photodétecteurs que de voies à verrouiller. Un autre but de l'invention est de fournir un moyen de verrouillage permettant d'éviter de verrouiller plusieurs filtres sur une unique fréquence d'émission d'une source de rayonnement multispectral.

### BREVE DESCRIPTION DE L'INVENTION

En vue de la réalisation de ce but, l'objet de l'invention propose un procédé de positionnement spectral d'un système photonique tel que défini dans la revendication 1

Selon d'autres caractéristiques avantageuses et non limitatives de l'invention, prises seules ou selon toute combinaison techniquement réalisable :
- le premier signal de verrouillage est représentatif de la puissance d'une deuxième harmonique de la fréquence de modulation et la deuxième opération vise à maximiser l'amplitude du premier signal de verrouillage, ou le premier signal de verrouillage est représentatif de la puissance de la composante principale de la fréquence de modulation et la deuxième opération vise à minimiser l'amplitude du premier signal de verrouillage ;
- le premier signal de verrouillage est formé du rapport entre la puissance de la deuxième harmonique de la fréquence de modulation et la puissance de la composante principale de la fréquence de modulation, la deuxième opération visant à optimiser l'amplitude du premier signal de verrouillage pour qu'il soit égal ou supérieur à une valeur déterminée ;

- la première opération produit au moins un deuxième signal de verrouillage représentatif de la phase du signal numérique de contrôle d'une composante principale de la fréquence de modulation présente dans le signal numérique de contrôle ;
- le deuxième signal de verrouillage correspond à la différence entre la phase d'une composante principale de la fréquence de modulation présente dans le signal numérique de contrôle et la phase d'un signal de modulation ou d'un signal de référence ;
- la première opération comprend une transformée de fourrier du signal numérique de contrôle ;
- le procédé comprend une étape de sélection d'un seul des dispositifs d'ajustement, l'étape de sélection étant répétée pour sélectionner successivement chacun des dispositifs d'ajustement ;
- les fréquences de modulation des dispositifs d'ajustement sont distinctes les unes des autres ;
- la commande d'ajustement est appliquée aux dispositifs d'ajustements un filtre optique à la fois.

Selon un autre aspect, l'objet de l'invention propose un système photonique de positionnement spectral d'un dispositif photonique tel que défini dans la revendication 10

Selon d'autres caractéristiques avantageuses et non limitatives de l'invention, prises seules ou selon toute combinaison techniquement réalisable :
- le système photonique comprend un unique photodétecteur couplé à un guide d'onde ;
- les filtres sont des filtres élémentaires couplés ;
- le dispositif photonique est un laser accordable ;
- le dispositif photonique est un routeur optique ;
- la source laser comprend une pluralité de lasers émettant une pluralité de fréquences d'émission ;
- des dispositifs d'ajustement associés aux lasers de la source sont commandés pour moduler les fréquences d'émission de la source et des dispositifs d'ajustement associés aux filtres sont commandés pour ajuster la fréquence de résonnance du filtre.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1a]
[Fig. 1b]
[Fig. 1c]
[Fig. 1d]
[Fig. 1e]

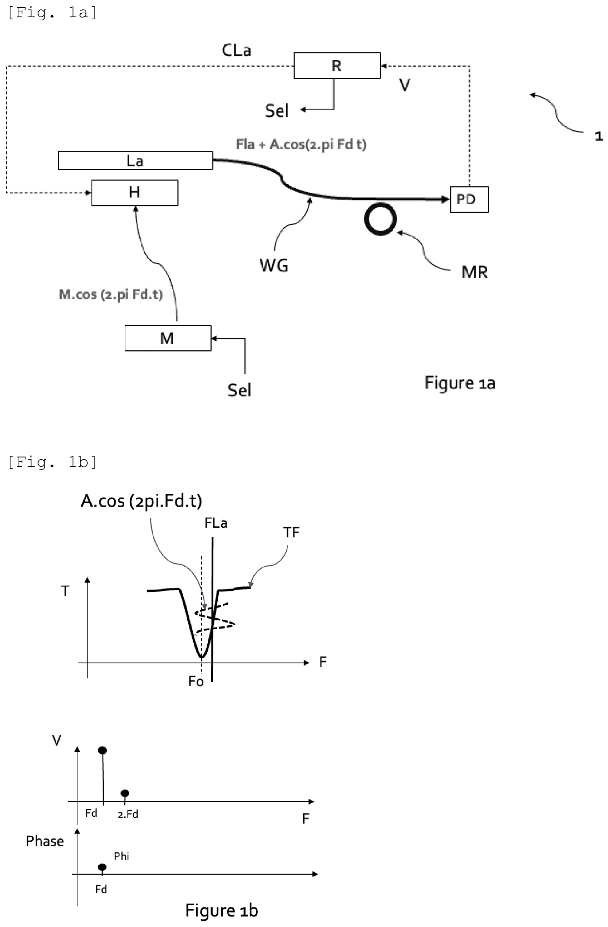

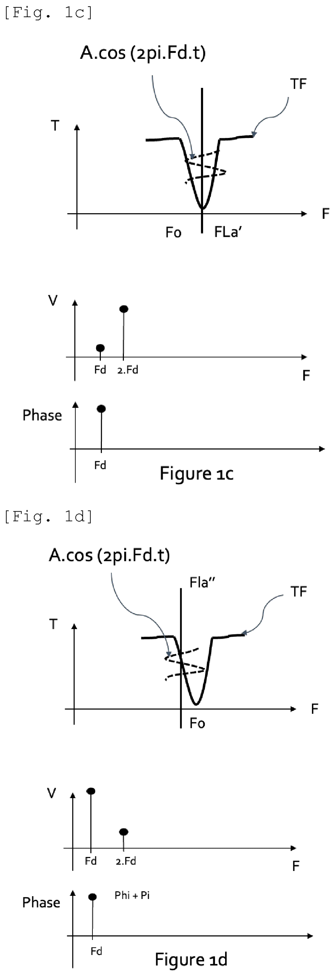

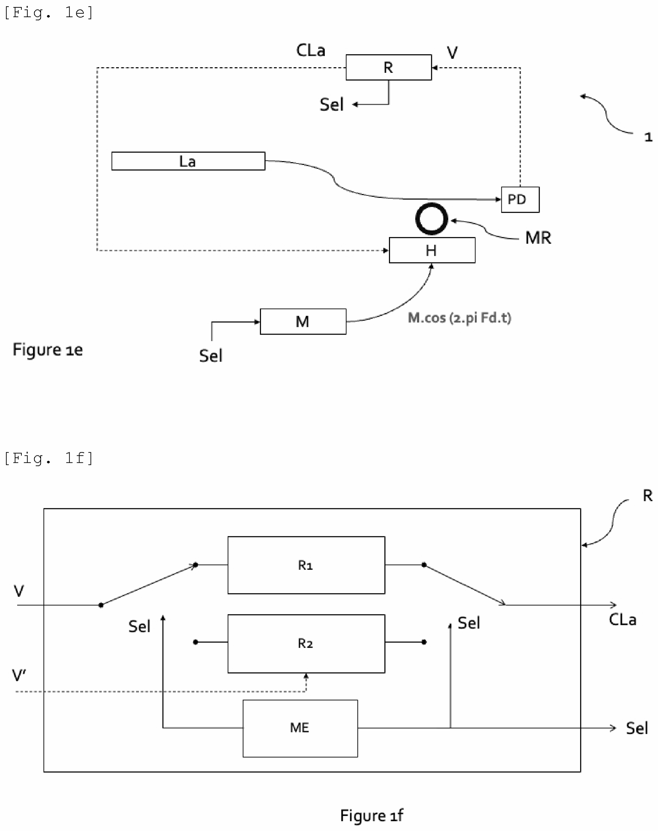

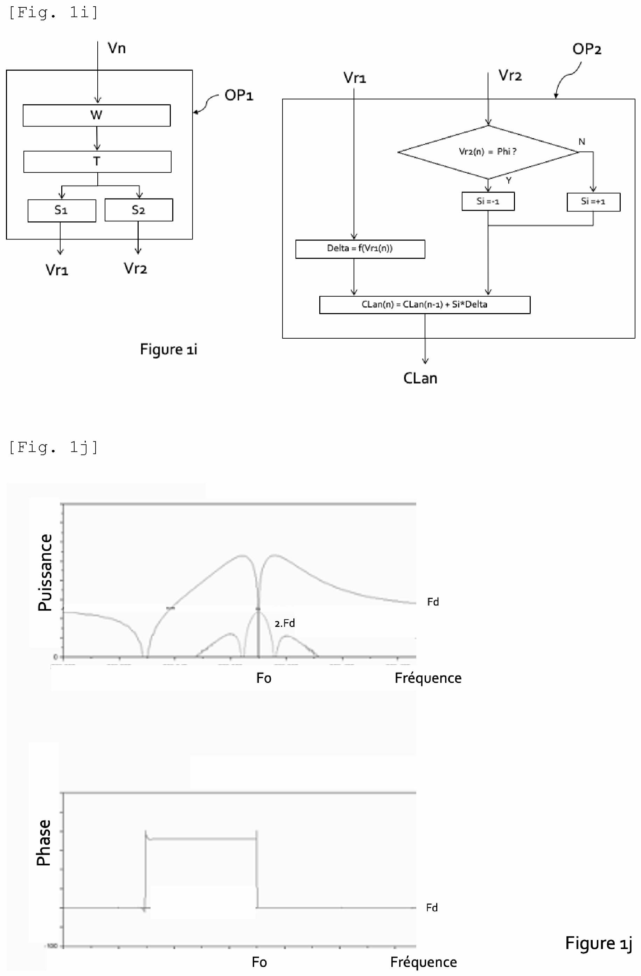

[Fig. 1j] Les figures 1a, 1b, 1c, 1d, 1e et 1j représentent des schémas des principes sous-tendant l'invention ;
[Fig. 1f] La figure 1f représente un dispositif de verrouillage pouvant mettre en œuvre un procédé selon l'invention ;

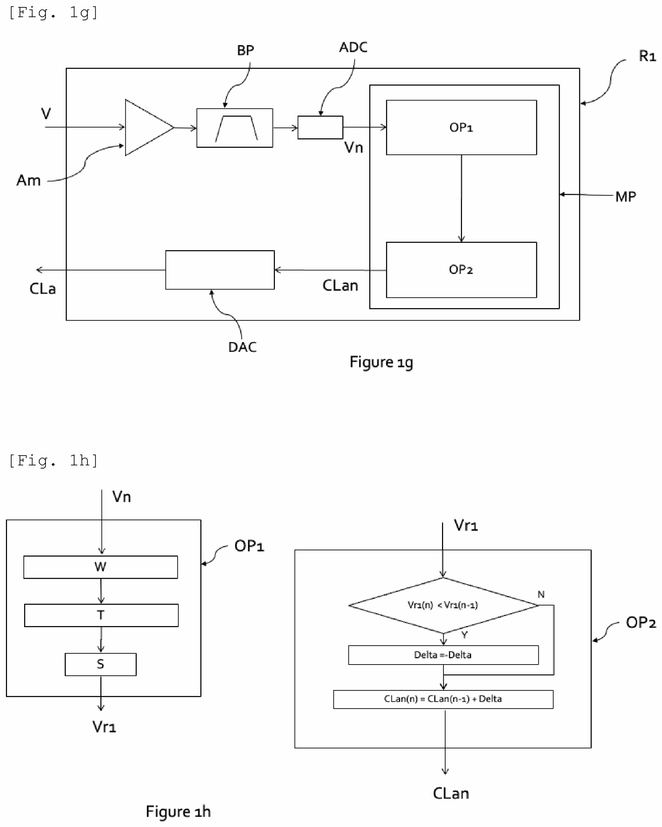

[Fig. 1g] La figure 1g représente une première partie d'un dispositif de verrouillage pouvant mettre en œuvre un premier mode de fonctionnement ;
[Fig. 1h]
[Fig. 1i] Les figures 1h, 1i représentent deux variantes des traitements mis en œuvre par le dispositif de verrouillage de la figure 1g ;
[Fig. 2a]
[Fig. 2b]
[Fig. 2c]
[Fig. 2d]

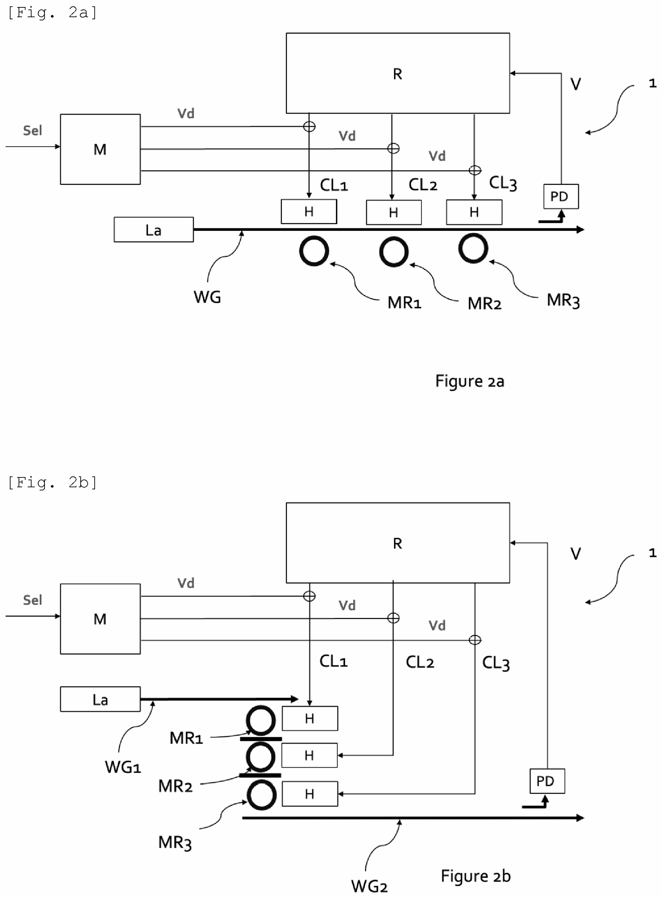

Les figures 2a à 2d représentent des variantes d'un premier mode de réalisation de l'invention, en multiplexage temporel ;
[Fig. 3a]
[Fig. 3b]
[Fig. 3c]
[Fig. 3d]

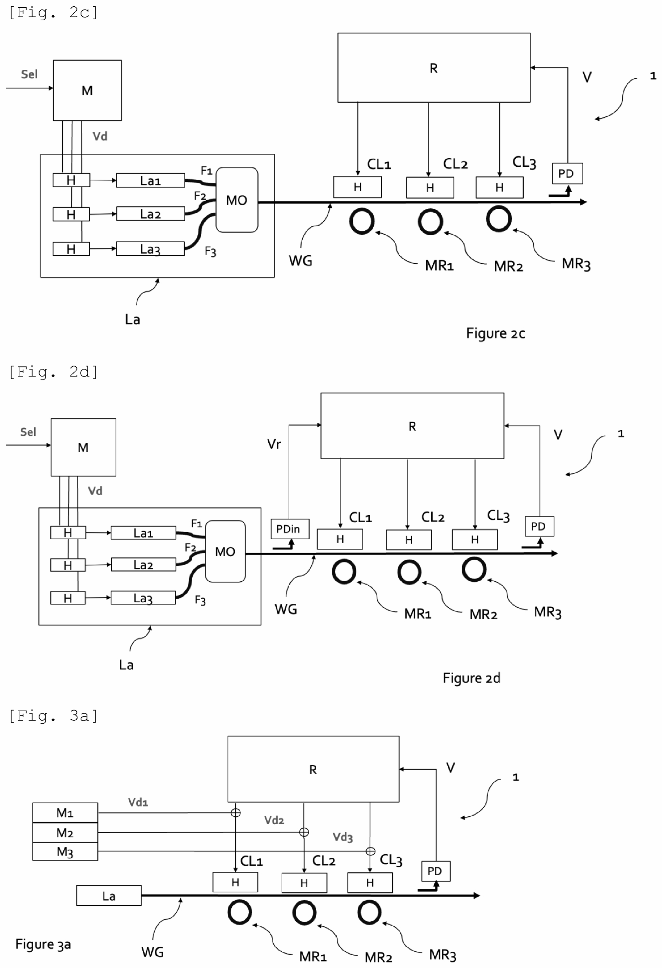

Les figures 3a à 3d représentent des variantes d'un deuxième mode de réalisation de l'invention, en multiplexage fréquentiel ;
[Fig. 4a]
[Fig. 4b]
[Fig. 4c]
[Fig. 4d]
[Fig. 4e]
[Fig. 4f]
[Fig. 4g]

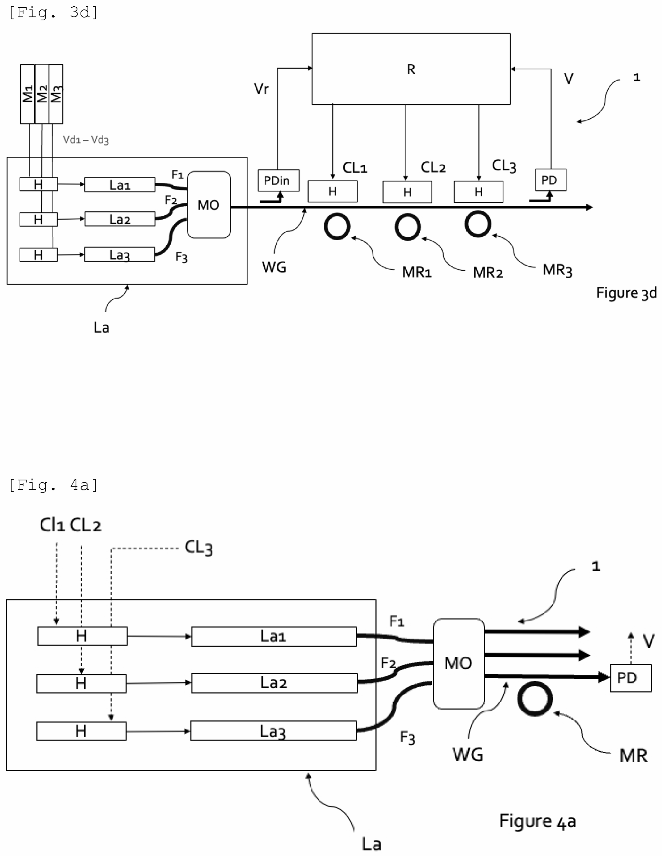

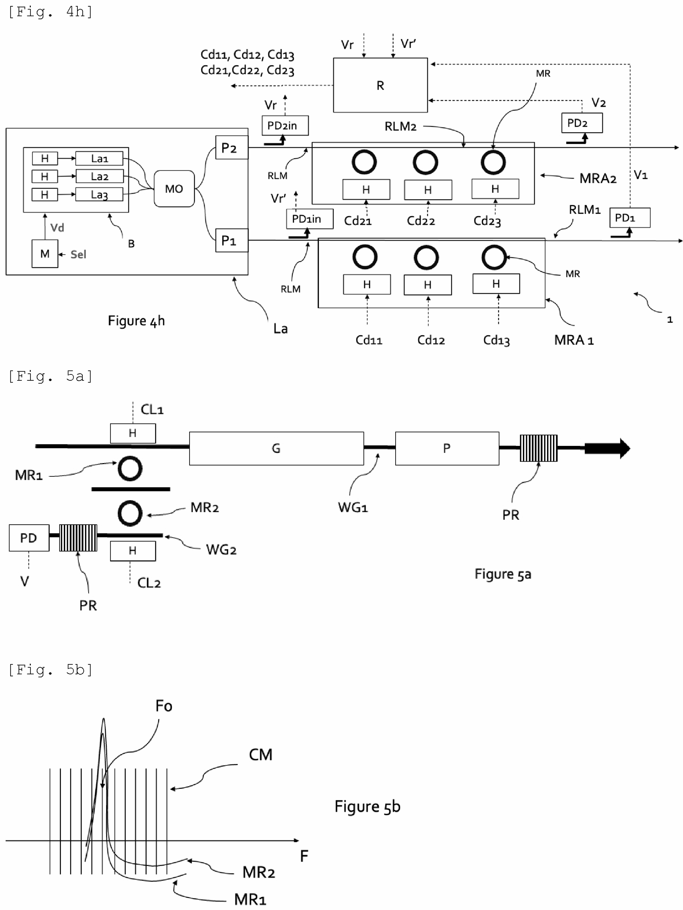

[Fig. 4h] Les figures 4a à 4h représentent une première application d'un procédé conforme à l'invention ;
[Fig. 5a]
[Fig. 5b] Les figures 5a, 5b représentent une deuxième application d'un procédé conforme à l'invention ;
[Fig. 6a]
[Fig. 6b]

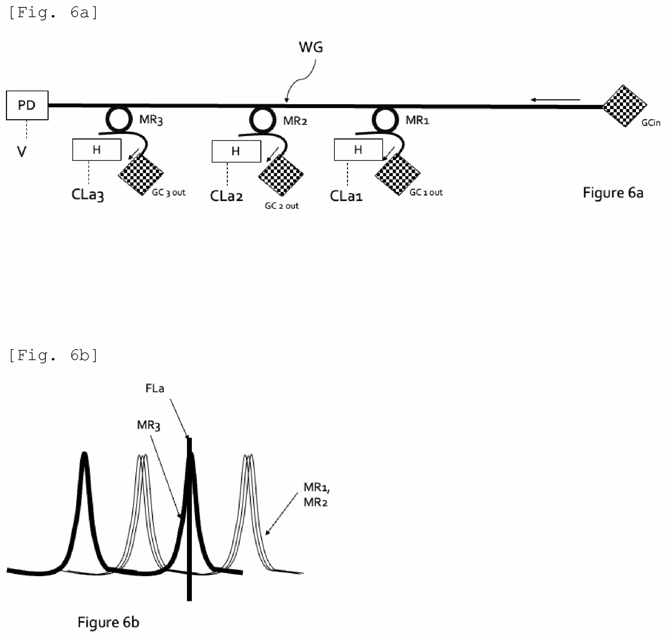

Les figures 6a, 6b illustrent une troisième application d'un procédé conforme à l'invention.

### DESCRIPTION DETAILLEE DE L'INVENTION

### Principes de l'invention

Les figures 1a, 1b, 1c, 1d et 1e sont des schémas des principes sous-tendant l'invention. Sur l'architecture du système photonique pris en exemple sur la figure 1a, un rayonnement lumineux issu d'une source laser La est guidé vers un résonateur en anneau MR, constituant un filtre, et présentant une fréquence de résonance F0, et vers un photodétecteur PD disposé en aval du résonateur MR. A cet effet, le système photonique comprend un guide d'onde WG configuré pour coupler optiquement le rayonnement produit par la source laser La au filtre MR et au photodétecteur PD.

Dans l'exemple de la figure 1a, la source laser La est un laser accordable. Par « laser accordable », on désigne un laser produisant un rayonnement lumineux dont la fréquence (« la fréquence d'émission ») peut être ajustée par l'intermédiaire d'un dispositif d'ajustement H de la fréquence d'émission. Ce dispositif d'ajustement H peut être configuré pour modifier le courant d'alimentation de la source, sa température de fonctionnement, son indice optique et/ou la concentration en porteurs libres. Un laser accordable peut être muni d'une pluralité de dispositifs d'ajustement de sa fréquence d'émission, par exemple une source de courant ajustable et un réchauffeur permettant de modifier sa température de fonctionnement.

Un modulateur M, relié au dispositif d'ajustement de la fréquence d'émission du laser, est configuré pour moduler la fréquence d'émission Fla du rayonnement lumineux émis par le laser accordable La, d'une fréquence de modulation Fd. Cette fréquence de modulation Fd, par exemple de 5 kHz, est relativement faible comparée à la fréquence d'émission du laser, par exemple de 200 térahertz. L'amplitude de cette modulation est également faible, de l'ordre du gigahertz. A titre d'exemple, 1 mA d'amplitude de modulation du courant d'alimentation de la source laser La peut conduire à une variation de la fréquence d'émission FLa de l'ordre de plus ou moins 1 GHz. La fréquence du rayonnement lumineux émis par le laser accordable La varie donc à très faible fréquence Fd et avec une faible amplitude A (1GHz) autour de sa fréquence fondamentale FLa. La fréquence laser varie donc comme Fla + A.cos (2pi.Fd.t).

Le modulateur M est sélectivement activable, par l'intermédiaire d'un signal de sélection SEL, c'est-à-dire que selon l'état de ce signal, le modulateur M est activé, et module effectivement la fréquence d'émission du laser La ou le modulateur est désactivé, et il ne module alors pas la fréquence d'émission du laser La.

Sur la figure 1b, on a représenté dans le domaine fréquentiel la fonction de transmission T du filtre MR dont le spectre TF présente une fréquence de résonance F0, et le signal V fourni par ce photodétecteur PD dans le cas où la fréquence d'émission FLa du laser accordable La n'est pas verrouillée sur une fréquence de résonance F0 du résonateur MR, mais présente une fréquence d'émission Fla supérieure à la cette fréquence de résonance F0. La fréquence d'émission du laser accordable La étant disposée dans une section relativement linéaire de la fonction de transmission du résonateur MR, le signal de contrôle V fourni par le photodétecteur PD présente, dans le domaine fréquentiel, une composante principale Fd (correspondant à la fréquence de modulation) relativement importante vis-à-vis de ses harmoniques et notamment vis-à-vis de sa deuxième harmonique 2*Fd. Par ailleurs, la phase Phi de la composante principale Fd du signal de contrôle V est réduite, c'est-à-dire que cette composante principale est en phase avec le signal de modulation fourni par le modulateur M.

Sur la figure 1c, on a représenté, similairement à la figure 1b, la fonction de transmission T du filtre MR dont le spectre TF présente une fréquence de résonance F0 et le signal de contrôle V fourni par ce photodétecteur PD dans le cas où la fréquence d'émission FLa' du laser accordable La est verrouillée sur la fréquence de résonance F0 du résonateur MR. Dans ce cas, la fréquence d'émission FLa' du laser accordable La est disposé dans une section relativement non linéaire de la fonction de transmission du résonateur MR. En conséquence le signal de contrôle V fourni par le photodétecteur PD présente, dans le domaine fréquentiel, une composante de deuxième harmonique 2*Fd relativement importante vis-à-vis de de la fréquence de modulation Fd.

Enfin, sur la figure 1d, on a représenté dans le domaine fréquentiel la fonction de transmission T du filtre MR dont le spectre TF présente une fréquence de résonance F0, et le signal de contrôle V fourni par ce photodétecteur PD dans le cas où la fréquence d'émission FLa du laser accordable La n'est pas verrouillée sur une fréquence de résonance F0 du résonateur MR, mais présente une fréquence d'émission Fla'' inférieure à la cette fréquence de résonance F0. La fréquence d'émission du laser accordable La étant disposée dans une section relativement linéaire de la fonction de transmission du résonateur MR, le signal de contrôle V fourni par le photodétecteur PD présente, dans le domaine fréquentiel, une composante principale Fd relativement importante vis-à-vis de ses harmoniques, et notamment vis-à-vis de sa deuxième harmonique 2*Fd. Par ailleurs, la phase Phi+Pi de la composante principale Fd du signal de contrôle V est importante, c'est-à-dire que cette composante principale est en opposition de phase avec le signal de modulation fourni par le modulateur M.

La figure 1j synthétise les résultats des figures 1b, 1c et 1d et représente, dans le graphe du haut, l'évolution de la puissance présente dans la composante principale Fd et dans la deuxième harmonique 2*Fd du signal V fourni par le photodétecteur quand la fréquence d'émission FLa du laser accordable La est modifiée et que la fréquence de résonance du filtre reste fixe (ou vice versa). La figure 1j représente également, dans le graphe du bas, l'évolution de la phase de la composante principale Fd du signal V fourni par le photodétecteur.

Revenant à la description du schéma de principe de la figure 1a, un dispositif de verrouillage R reçoit le signal de contrôle V fourni par le photodétecteur PD et le traite pour élaborer une commande CLa du laser accordable La visant à accorder sa fréquence d'émission pour la verrouiller sur la fréquence de résonance F0 du résonateur MR. Le dispositif de verrouillage R produit également le signal de sélection Sel, permettant d'activer ou désactiver le modulateur M. Optionnellement, le dispositif de verrouillage peut présenter une entrée additionnelle V' permettant de recueillir une grandeur représentative de la puissance émise par le laser, i.e. via par exemple un photodétecteur disposé près du laser La, sur une voie optique disposée en amont du filtre MR.

La figure 1f représente un dispositif de verrouillage R selon un mode de mise en œuvre. Ce dispositif comprend une première partie R1 apte à mettre en œuvre le système photonique 1 selon un premier mode de fonctionnement au cours de laquelle le modulateur M est activé. Dans ce premier mode de fonctionnement, le signal de sélection Sel est donc activé par le dispositif de verrouillage R. Dans ce premier mode également, le dispositif de verrouillage R produit une commande d'ajustement à partir d'un premier signal de verrouillage Vr1 représentatif de la puissance d'une seconde harmonique de la fréquence de modulation présente dans le signal de contrôle V. Ce premier mode de fonctionnement fait l'objet d'une description détaillée dans une section ultérieure de ce document, mais d'une manière générale et comme on l'a exposé en relation avec la description de ces figures 1b,1c,1d, ce mode de fonctionnement exploite le résultat selon lequel, lorsque le signal de contrôle présente une seconde harmonique 2*Fd maximale, la fréquence d'émission Fla et la fréquence de résonnance F0 se correspondent.

Bien que ce mode de fonctionnement soit particulièrement efficace, le modulateur peut conduire à perturber les canaux de transmission des données utiles.

Aussi, pour éviter un fonctionnement continu du dispositif de régulation dans le premier mode de fonctionnement, le dispositif de verrouillage R comprend également une seconde partie R2 apte à mettre en œuvre le système photonique 1 selon un second mode de fonctionnement dans lequel le modulateur M est désactivé. Dans ce second mode de fonctionnement, le signal de sélection Sel est donc désactivé par le dispositif de verrouillage R. Dans ce second mode également, le dispositif de verrouillage R produit une commande d'ajustement CLa à partir d'un troisième signal de verrouillage représentatif de la puissance présente dans le signal de contrôle V. Cette seconde partie peut mettre en œuvre une méthode de gradient, c'est à dire produire une commande d'ajustement CLa visant à maximiser le signal de contrôle V. Lorsque le dispositif de verrouillage R présente une entrée additionnelle V' permettant de recueillir une grandeur représentative de la puissance émise par le laser, la méthode de gradient peut s'appliquer à une fonction prenant en argument le signal de contrôle V et l'entrée additionnelle V' : il peut s'agir de la différence V'-V, ou du rapport V/V' de ces deux grandeurs que l'on peut chercher à maximiser ou à minimiser.

La seconde partie R2 apte à mettre en œuvre le second mode de fonctionnement peut correspondre à un microcontrôleur, un microprocesseur de traitement de signal, un FPGA ou tout autre dispositif de calcul. Ce dispositif de calcul peut être le même que celui exploité dans la première partie R1 du dispositif de verrouillage, comme cela sera détaillé dans une section prochaine de cette divulgation. Les étapes de gradient mises en œuvre par le dispositif de calcul dans le second mode de fonctionnement sont bien connues en soi et ne mérite pas plus d'explication.

Le dispositif de verrouillage R comprend également une machine d'état ME produisant le signal de sélection Sel permettant de basculer entre les deux modes de fonctionnements. A titre d'exemple, la machine d'état ME peut être configurée pour opérer le dispositif de verrouillage dans le premier mode de fonctionnement au démarrage du système et pendant une durée prédéterminée, puis de basculer dans le second mode de fonctionnement.

Cette bascule peut être opérée sur un autre critère que le temps écoulé : il peut par exemple s'agir d'un critère de performance du verrouillage, par exemple lorsque le signal de contrôle atteint une valeur cible ou lorsque des mesures extraites de ce signal de contrôle atteignent une valeur cible.

Il peut être prévu que la bascule dans le second mode de mise en œuvre soit permanente. En alternative, il peut être prévu que la machine d'état ME du dispositif de verrouillage R alterne entre le premier mode de fonctionnement et le second mode de fonctionnement, de manière régulière ou selon l'évolution d'un critère de performance.

Un système photonique muni d'un tel dispositif de verrouillage bénéficie à la fois de la performance du premier mode de fonctionnement permettant de verrouiller le système 1 pour qu'il fonctionne de manière nominale, sans toutefois subir de manière permanente les perturbations de transmission provoquées par le fonctionnent du modulateur M.

### Première partie R1 du dispositif de verrouillage

Cette première partie R1 du dispositif de verrouillage est représentée sur la figure 1g et comprend tout d'abord une première section de conditionnement du signal de contrôle V fourni par le photodétecteur PD. Cette première section comprend un amplificateur Am, un filtre BP et un convertisseur numérique ADC et fournit un signal numérique de contrôle Vn. Dans cette section, le signal de contrôle V fourni par le photodétecteur PD est reçu par l'amplificateur Am, par exemple un amplificateur de transimpédance ou un amplificateur logarithmique. Le signal de contrôle V amplifié est appliqué au filtre BP, par exemple un filtre passe-bande s'étendant sur une gamme de fréquences de travail définie par une fréquence de coupure minimale et une fréquence de coupure maximale. La gamme de fréquence de travail est choisie pour incorporer la fréquence de modulation et son harmonique de second ordre, c'est-à-dire que la fréquence de coupure maximale est choisie pour être au moins égale à deux fois la fréquence de modulation Fd. Le signal produit par le filtre est échantillonné par un convertisseur analogique digital ADC, pour fournir un signal de contrôle numérique Vn, la fréquence d'échantillonnage étant choisie supérieure (par exemple 2 à 10 fois supérieur) à deux fois la fréquence de coupure maximale du filtre BP, donc bien supérieure à quatre fois supérieure à la fréquence de modulation Fd. A titre d'illustration, lorsque la fréquence de modulation (ou la fréquence de modulation maximale, lorsque plusieurs fréquences sont exploitées comme cela sera exposé dans une section ultérieure de cette description) est de 30kHz, on pourra choisir une fréquence d'échantillonnage de 128kHz, ou supérieure.

Le signal numérique de contrôle Vn est traité par un dispositif de calcul MP qui peut correspondre à un microcontrôleur, un microprocesseur de traitement de signal, un FPGA ou tout autre dispositif de calcul. Le dispositif de calcul produit au moins un signal numérique, dit « signal de verrouillage », destiné à former la commande d'ajustement CLa du dispositif d'ajustement de fréquence. Dans l'exemple représenté sur la figure 1f, cette commande d'ajustement CLa est formée par une seconde section de conditionnement d'une commande d'ajustement numérique CLan, la seconde section de conditionnement consistant ici en un convertisseur numérique analogique DAC.

Bien entendu, la première et la seconde section de conditionnement pourraient comprendre d'autres éléments, en complément ou en remplacement, que ceux représentés à titre d'exemple sur la figure 1g. On peut notamment prévoir que les convertisseurs ADC, DAC soient intégrés dans le dispositif de calcul MP et non dans les sections de conditionnements des signaux.

D'une manière très générale, le dispositif de calcul MP met en œuvre des traitements exploitant les résultats présentés dans les figures 1b, 1c, 1d pour déterminer une commande CLa à appliquer au moyen d'ajustement H de la fréquence d'émission du laser visant à maximiser la part du signal présente dans la seconde harmonique 2*Fd du signal de contrôle fourni par le photodétecteur PD. Comme on l'a exposé en relation avec la description de ces figures 1b,1c,1d, lorsque cette part de signal présente dans la seconde harmonique 2*Fd est maximale, le système est bien verrouillé, c'est-à-dire que la fréquence d'émission Fla et la fréquence de résonnance F0 se correspondent. On note que la part du signal présent dans la composante principale Fd et la part du signal présent dans la seconde harmonique 2*Fd sont liées l'une à l'autre, comme cela est bien visible sur la figure 1j, si bien que l'on pourra choisir d'exploiter l'une et/ou l'autre selon le besoin. On note également que la phase peut être utilisée en complément de l'une ou de l'autre de ces parts de signaux.

Plus généralement encore, la détermination de la commande CLa est réalisée par optimisation d'une fonction prenant en argument la part du signal présente dans la seconde harmonique 2*Fd et/ou d'une composante principale Fd du signal de contrôle V. Le critère d'optimisation peut correspondre à ce que la fonction atteigne une valeur cible, soit inférieur à une valeur plafond prédéterminée ou soit supérieur à une valeur seuil prédéterminée.

A titre d'exemple, on peut ainsi chercher à fixer le rapport entre la part de signal dans la seconde harmonique et la part du signal présent dans composante principale Fd pour qu'il soit égal à une valeur cible ou pour le maximiser.

Par souci de précision, on dira que le système est « verrouillé » lorsque le critère d'optimisation choisi est satisfait. Cela peut correspondre à la situation dans laquelle la fréquence d'émission Fla et la fréquence de résonnance F0 se correspondent ou lorsque ces fréquences sont décalées l'une de l'autre d'un écart déterminé.

Revenant à la description de la figure 1g, les traitements mis en œuvre par le dispositif de calcul MP comprennent :
- Une première opération OP1 de traitement du signal numérique de contrôle pour produire au moins un signal numérique Vr1, dit « premier signal de verrouillage », représentatif de la puissance d'une deuxième harmonique de la fréquence de modulation présente dans le signal numérique de contrôle Vn ;
- Une deuxième opération OP2 de traitement du premier signal de verrouillage Vr1 pour produire une commande numérique d'ajustement CLan, la deuxième opération OP2 de traitement visant à optimiser une fonction d'optimisation prenant en argument le premier signal de verrouillage Vr1.

Par exemple, la deuxième opération OP2 de traitement peut viser à maximiser l'amplitude du premier signal de verrouillage Vr1.

La figure 1h représente les opérations OP1, OP2 mise en œuvre par le dispositif de calcul MP selon une première approche. La première opération OP1 de traitement du signal numérique de contrôle Vn comprend ainsi une première étape de fenêtrage temporel W suivi d'une seconde étape T de transformation dans le domaine fréquentiel. Cette seconde étape T peut ainsi être une transformée de Fourrier rapide, mais toute autre transformation numérique dans le domaine fréquentiel peut convenir. Cette transformation peut fournir une répartition spectrale de puissance et de phase, bien que seule l'information de puissance soit exploitée dans la première approche représentée sur la figure 1g. Comme cela est bien connu en soi, l'étape de fenêtrage W vise à déterminer la portion du signal numérique de contrôle Vn sur lequel s'applique la transformation en fréquence et, éventuellement à conditionner cette séquence. Il peut ainsi s'agir d'une simple fenêtre rectangulaire, d'une fenêtre de Hanning ou de Hamming. La longueur de cette fenêtre temporelle, c'est-à-dire le nombre d'échantillons temporels retenus dans la portion du signal numérique de contrôle Vn sur lequel s'applique la transformation en fréquence, définit la résolution en fréquence du signal produit à l'issue de l'étape de transformation T, et donc la possibilité de discriminer la puissance présente dans une gamme de fréquences. A titre d'illustration, une longueur de 1024 échantillons permet d'obtenir une résolution de 125 Hz dans le signal numérique produit par l'étape de transformation T lorsque la fréquence d'échantillonnage est de 125kHz. Reprenant la description de la première opération OP1 représentée sur la figure 1g, l'étape de transformation T est suivie d'une étape de sélection S au cours de laquelle on sélectionne dans le signal produit par l'étape de transformation l'échantillon correspondant à la deuxième harmonique 2Fd du signal de modulation Fd. Cette étape de sélection S conduit donc à produire un signal numérique Vr1 appelé « premier signal de verrouillage » dans la suite de cette description, ce premier signal de verrouillage étant représentatif de la puissance d'une deuxième harmonique de la fréquence de modulation présente dans le signal numérique de contrôle Vn. Lorsque le signal de contrôle V incorpore plusieurs signaux de modulation, comme cela sera détaillé dans la suite de cette description, l'étape de sélection produit une pluralité d'échantillons, chaque échantillon correspondant à la deuxième harmonique d'un des signaux de modulation. La première opération OP1 fournit dans ce cas une pluralité de premiers signaux de verrouillage, chaque signal étant associé à un signal de modulation particulier.

Le premier signal de verrouillage Vr1 peut correspondre à la puissance d'une deuxième harmonique de la fréquence de modulation présente dans le signal numérique de contrôle Vn. Plus généralement, ce signal de verrouillage peut correspondre à toute fonction prenant en argument cette puissance de deuxième harmonique. Cette fonction peut notamment être le rapport entre la part de signal dans la seconde harmonique et la part du signal présent dans la fréquence fondamentale.

La figure 1h représente également la seconde opération OP2 mise en œuvre par le dispositif de calcul MP selon la première approche. Cette seconde opération OP2 traite le premier signal de verrouillage Vr1 élaboré au cours de la première opération OP1. Au cours d'une première étape de comparaison, on compare la valeur de l'échantillon Vr1(n), produit à l'instant n, du premier signal de verrouillage Vr1, avec la valeur de l'échantillon Vr1(n-1) produit à l'instant précédent n-1, qui a donc été mémorisé. Selon le résultat de cette comparaison on incrémente ou on décrémente d'une valeur d'incrémentation prédéterminée Delta, la commande numérique d'ajustement Clan élaborée produit à l'instant précédent n-1 pour élaborer cette commande numérique à l'instant n. On comprend donc que cette seconde opération OP2 vise à maximiser l'amplitude du premier signal de verrouillage Vr1 (représentatif de la puissance d'une deuxième harmonique de la fréquence de modulation dans le signal numérique de contrôle Vn), en faisant évoluer, à la hausse ou à la baisse, la commande numérique d'ajustement Clan. Lorsque le signal de contrôle V incorpore plusieurs signaux de modulation, et donc comme on l'a présenté dans le paragraphe précédent la première opération produit une pluralité de premiers signaux de verrouillage Vr1, une pluralité de seconde opération s'exécute de manière concurrente, chaque seconde opération traitant un premier signal de verrouillage Vr1 parmi la pluralité produite par la première opération.

La seconde étape de comparaison pourrait être rendue différente de la simple comparaison entre deux échantillons successifs présentée dans cet exemple conduisant à maximiser l'amplitude du premier signal de verrouillage Vr1. On choisira cette étape de comparaison selon le critère d'optimisation choisi, c'est-à-dire selon que l'on cherche à maximiser, à minimiser ou à rendre égal à une valeur déterminée le signal de verrouillage.

La figure 1i représente les opérations OP1, OP2 mise en œuvre par le dispositif de calcul MP selon une seconde approche. La première opération OP1 de traitement du signal numérique de contrôle Vn comprend les mêmes première étape de fenêtrage W et seconde étape T de transformation dans le domaine fréquentiel que celle de la première approche. Ces étapes sont suivies de deux étapes concurrentes de sélection S1, S2 produisant deux signaux de verrouillage Vr1, Vr2. La première étape de sélection S1 produisant le premier signal de verrouillage Vr1 est identique à l'étape de sélection de la première approche. Au cours de la seconde étape de sélection S2 on sélectionne, dans le signal produit par l'étape de transformation, l'échantillon correspondant à la phase de la fréquence de modulation Fd (le fondamental). Cette étape de sélection S2 conduit donc à produire un signal numérique Vr2 appelé « deuxième signal de verrouillage » dans la suite de cette description, ce deuxième signal de verrouillage étant représentatif de la phase du fondamental de la fréquence de modulation présente dans le signal numérique de contrôle Vn.

La figure 1i représente également la seconde opération OP2 mise en œuvre par le dispositif de calcul MP selon la seconde approche. Cette seconde opération préserve le principe exposé dans la description détaillée de la première approche selon lequel on cherche à optimiser l'amplitude du premier signal de verrouillage Vr1, en faisant évoluer, à la hausse ou à la baisse, la commande numérique d'ajustement Clan. On retrouve bien l'étape d'incrémentation ou de décrémentation d'une valeur d'incrémentation Delta de la commande numérique d'ajustement élaborée à l'instant précédent n-1 pour élaborer cette commande numérique à l'instant n. Selon cette seconde approche toutefois, le signe Si appliqué à la valeur d'incrémentation Delta est déterminé par une étape de comparaison entre le deuxième signal de verrouillage Vr2 avec la phase Phi du signal de modulation. Comme cela a été présenté préalablement, cette comparaison sur les phases permet de déterminer position relative de la fréquence d'émission et de la fréquence de résonnance du filtre. La valeur d'incrémentation Delta est quant à elle déterminée par l'intermédiaire d'une fonction métrique f qui s'applique au premier signal de verrouillage Vr1. A titre d'exemple cette fonction peut consister à déterminer la proportion relative de la puissance présente dans la seconde harmonique vis-à-vis de la puissance totale mesurée dans le spectre ou de la puissance présente dans la fréquence fondamentale. On pourra bien entendu choisir de définir le deuxième signal de verrouillage Vr2 comme la différence entre la phase de la composante principale de la fréquence de modulation présente dans le signal numérique de contrôle Vn et la phase Phi du signal de modulation.

Lorsque le signal de contrôle V incorpore plusieurs signaux de modulation, les mêmes principes que ceux exposés dans le cadre de la première approche s'appliquent, ces principes conduisant à fournir, à l'issue de la première opération OP1, une pluralité de premier et deuxième signaux de verrouillage Vr1, Vr2, et chaque couple de signaux de verrouillage Vr1, Vr2 étant traité par une instance de la deuxième opération OP2, ces instances de la deuxième opération OP2 s'exécutant de manière concurrente.

Dans une variante, la deuxième opération OP2 pourrait se fonder sur le seul traitement du second signal de verrouillage Vr2 pour produire la commande numérique d'ajustement CLan. Cette deuxième opération OP2 se fonde alors sur ce second signal de verrouillage Vr2 pour produire la commande CLan. On peut notamment envisager une première phase de positionnement spectral se fondant uniquement sur le second signal de verrouillage Vr2 uniquement, suivi d'une seconde phase de positionnement spectral se fondant sur le premier signal de verrouillage Vr1. Cette second phase peut également exploiter le second signal de verrouillage Vr2, comme cela vient d'être présenté.

Pour conclure cette section portant sur les principes généraux exploités dans le premier mode de fonctionnement, on note qu'en appliquant, à l'aide du modulateur M, un signal de modulation sinusoïdal, c'est-à-dire en appliquant une modulation spectralement pure à la fréquence d'émission, on limite l'apparition d'harmoniques dans le signal de contrôle V fourni par le photodétecteur PD (par comparaison avec une modulation en créneau par exemple). Les harmoniques détectées par la première partie R1 du dispositif de verrouillage R sont alors bien représentatives de la qualité du verrouillage entre la fréquence d'émission et la fréquence de résonnance.

On note également que les mêmes principes de verrouillage sont applicables à une configuration dans laquelle le laser présente une fréquence d'émission fixe, et dans laquelle le dispositif d'ajustement H est associé au filtre MR de manière à ajuster sa fréquence de résonance. Cette configuration est représentée sur la figure 1e. Le dispositif d'ajustement H dans ce cas peut être un réchauffeur, permettant d'ajuster la température de fonctionnement du filtre et donc sa fréquence de résonnance.

Enfin, il n'est pas nécessaire que le modulateur M soit un élément séparé du système photonique 1 : il peut être par exemple intégré au dispositif de verrouillage R lui-même, celui-ci produisant donc le signal de modulation et l'appliquant au dispositif d'ajustement H exploité pour moduler la fréquence d'émission ou de résonnance. Si un même dispositif d'ajustement H est exploité à la fois pour moduler et ajuster la fréquence d'émission d'un laser ou de résonnance d'un filtre, le dispositif de verrouillage R peut simplement procéder à la somme du signal de modulation et du signal de commande, et le signal résultant de cette somme appliqué à cet unique dispositif d'ajustement H.

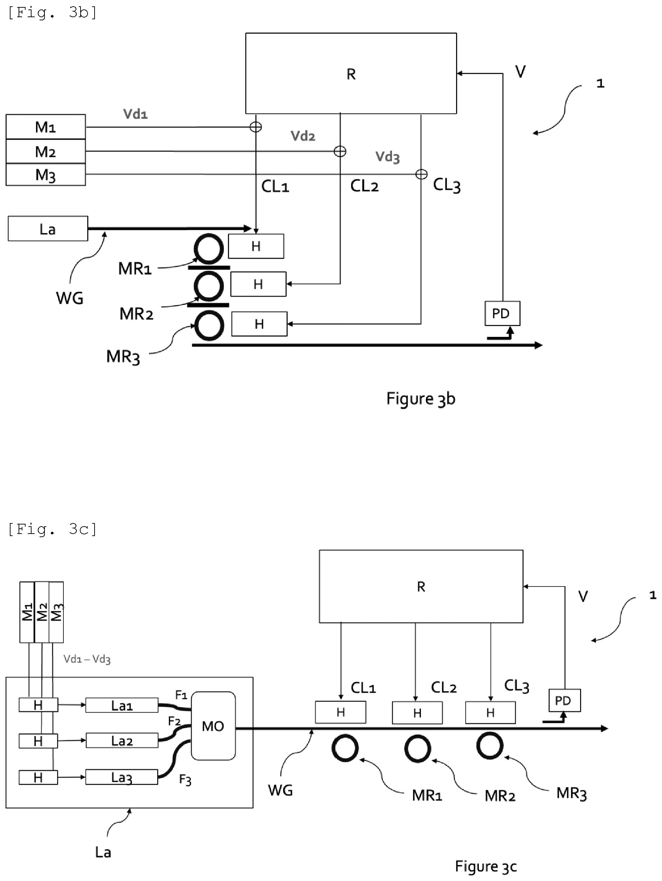

Les principes du premier mode de fonctionnement du dispositif de verrouillage qui viennent d'être présentés trouvent tout leur intérêt lorsqu'une pluralité d'éléments dans le système photonique 1 doit être verrouillée entre eux. C'est notamment le cas lorsque le système photonique 1 est composé d'une pluralité de filtres, comme cela est le cas sur les figures 2a, 2c et 3a. C'est également le cas lorsque le système photonique est composé d'un filtre composé d'une pluralité de filtres élémentaires couplés entre eux comme cela est représenté sur les figures 2b et 3b. Dans tous les cas, on exploite préférentiellement un unique photodétecteur PD pour ajuster et verrouiller entre eux au moins une fréquence d'émission d'au moins une source laser La et au moins une fréquence de résonnance d'au moins un filtre MR.

### Verrouillage par multiplexage temporel

Dans ce premier mode de mise en œuvre du premier mode de fonctionnement, le système photonique 1 comprend une pluralité de dispositifs d'ajustement H sélectivement commandables et respectivement associés à une pluralité de filtres ou à une pluralité de sources laser. Le procédé de positionnement spectral du système photonique 1 comprend une étape de sélection d'un seul des dispositifs d'ajustement H associé à un filtre sur lequel est mis en œuvre les opérations de verrouillage.

Ainsi, sur l'exemple représenté sur les figures 2a et 2b, une pluralité de filtres en forme de micro anneaux MR1,MR2,MR3 sont couplés à un guide d'onde WG. On retrouve dans ces exemples, une source laser La en amont d'un guide d'onde WG, WG1 et le photodétecteur PD en aval de ce guide d'onde WG (figure 2a) ou d'un guide d'onde complémentaire WG2 (figure 2b). Le photodétecteur PD est couplé au guide d'onde WG ou au guide d'onde complémentaire pour prélever une partie au moins du rayonnement lumineux qui s'y propage. Dans l'exemple de la figure 2a, la source laser La émet un rayonnement présentant une pluralité de fréquences d'émission, et on cherche à accorder chaque filtre MR1,MR2,MR3 à l'une des fréquences d'émission de la source laser La. Dans l'exemple de la figure 2b, la source laser émet un rayonnement lumineux pouvant présenter une unique fréquence d'émission ou une pluralité de fréquences d'émission, et on cherche à accorder chaque filtre élémentaire MR1,MR2,MR3 sur l'une des fréquences d'émission de la source laser pour ajuster la fonction de transfert global du filtre.

Un modulateur M produit un signal de modulation Vd, de préférence spectralement pur et présentant donc une unique fréquence de modulation Fd. Ce signal de modulation est sélectivement appliqué à l'un seulement des dispositifs d'ajustement H, ici des réchauffeurs, à l'aide d'un signal de sélection Sel.

Dans le même temps, le dispositif de verrouillage R reçoit le signal de contrôle fourni par le photodétecteur PD et fournit un signal de commande CL1,CL2,CL3 au dispositif d'ajustement H sélectionné. Le dispositif de verrouillage R est ainsi configuré pour commander le modulateur M et sélectionner, à l'aide du signal de sélection Sel, le dispositif d'ajustement H auquel est appliqué le signal de modulation Vd et le signal de commande CL1,CL2,CL3. Le dispositif de verrouillage choisit de la sorte le filtre MR1,MR2,MR3 dont la fréquence de résonnance est accordée.

La figure 2c illustre un autre exemple de mise en œuvre en multiplexage temporel. Dans cet exemple, particulièrement avantageux, une unique fréquence d'émission est modulée par l'intermédiaire du signal de modulation Vd appliqué par le modulateur M à un dispositif d'ajustement H associé à un laser de la source La. Le dispositif de verrouillage R reçoit le signal de contrôle V fourni par le photodétecteur PD et contrôle un dispositif d'ajustement H associé à un filtre MR1,MR2,MR3 de manière à ajuster et verrouiller la fréquence de résonnance de ce filtre sur la fréquence d'émission du laser sélectionné.

La source laser La comprend une pluralité de laser La1,La2,La3 émettant des rayonnements présentant des fréquences d'émission F1,F2,F3 distinctes. Chaque laser peut être associé à un dispositif d'ajustement H, préférentiellement formé de sa source de courant. Les rayonnements issus des lasers sont combinés par un mélangeur optique MO pour produire un rayonnement lumineux multispectral présentant donc une pluralité de fréquences d'émission. Le signal de modulation Vd est sélectivement appliqué au dispositif d'ajustement H associé à l'un des lasers La1,La2,La3 de la source La, dont la fréquence d'émission est alors modulée. Dans le même temps, le dispositif de verrouillage R reçoit le signal de contrôle fourni par le photodétecteur PD et fourni un signal de commande CL1,CL2,CL3 au dispositif d'ajustement H associé à l'un des filtres MR1,MR2,MR3, de manière à le verrouiller sur la fréquence d'émission du laser.

La figure 2d représente une variante de l'exemple représenté sur la figure 2c qui est particulièrement adaptée lorsque la source laser La et les filtres MR1,MR2,MR3 sont constitués de composants photoniques distincts, ne pouvant communiquer entre eux. Dans cette variante, on prélève, en amont de la pluralité de filtres MR1,MR2,MR3 une partie du rayonnement lumineux multispectral se propageant sur le guide d'onde WG. Un photodétecteur d'entrée PDin mesure cette partie du rayonnement lumineux pour produire un signal de référence Vr et le fournir au dispositif de verrouillage R.

Le dispositif de verrouillage R peut dans ce cas combiner les informations présentes dans le signal de contrôle V et dans le signal de référence Vr pour élaborer le premier signal de verrouillage Vr1 et/ou le second signal de verrouillage Vr2.

Ces traitements peuvent chercher à établir, après transformation dans le domaine fréquentiel (par exemple par une transformée de Fourrier rapide) du signal de référence Vr, la phase et la puissance présente dans le fondamental et/ou dans la deuxième harmonique de la fréquence de modulation présente dans le signal de référence Vr.

Le premier signal de verrouillage Vr1 peut alors être construit comme le rapport de la puissance présente dans le fondamental (la fréquence de modulation Fd) du signal de référence sur la puissance présente dans le fondamental du signal de contrôle. Il peut alternativement s'agir d'élaborer le premier signal de verrouillage Vr1 comme le rapport de la puissance présente dans le second harmonique de la fréquence de modulation Fd du signal de référence Vr sur la puissance présente dans le second harmonique de la fréquence de modulation Fd du signal de contrôle V. D'une manière plus générale, le premier signal de verrouillage Vr1 peut combiner toutes informations extraites du signal de contrôle V et du signal de référence Vr. Les mêmes principes peuvent être exploités pour former un deuxième signal de verrouillage Vr2 combinant les informations de phase à la fréquence de modulation Fd (le fondamental) du signal de référence Vr et du signal de contrôle V. Il peut s'agir de prendre la différence entre ces deux phases.

Le deuxième signal de verrouillage Vr2 peut correspondre à la différence entre la phase d'une composante principale de la fréquence de modulation Fd présente dans le signal numérique de contrôle Vn et la phase du signal de référence (Vr).

Dans tous les exemples représentés sur les figures 2a à 2d de ce verrouillage en multiplexage temporel, la machine d'état du dispositif de verrouillage R peut être configurée pour établir le signal de sélection Sel sélectionnant circulairement un des dispositifs d'ajustement H relié au modulateur M, par exemple au cours de périodes de verrouillage successives dont la durée peut être typiquement comprise entre quelques microsecondes à quelques millisecondes. Au cours de chaque période de verrouillage, le dispositif de verrouillage R met en œuvre les opérations de verrouillage exposées précédemment et conduisant à verrouiller la fréquence de résonnance F0 du filtre ou filtre élémentaire sur une fréquence d'émission du laser La. A l'issue d'un cycle complet, chaque filtre ou filtre élémentaire MR1,MR2,MR3 est bien verrouillé sur une fréquence d'émission du laser La.

### Verrouillage par multiplexage en fréquence

Dans ce second mode de mis en œuvre du premier mode de fonctionnement, le système photonique 1 comprend également une pluralité de dispositifs d'ajustement respectivement H associés à une pluralité de filtres MR1,MR2,MR3 et/ou à une pluralité de laser La1,La2,La3. Le dispositif de verrouillage R produit également, concurremment, une pluralité de signaux de commande CL1,CL2,CL3 chaque signal de commande étant appliqué à un dispositif d'ajustement H d'un filtre. Pour permettre cela, les fréquences de modulation Vd1,Vd2,Vd3 appliquées aux dispositifs d'ajustement H par une pluralité de modulateurs M1,M2,M3 sont distinctes les unes des autres.

Ainsi, on retrouve sur les figures 3a à 3d, le système photonique 1 des exemples précédents comprenant la pluralité de filtre en micro-anneaux MR1,MR2,MR3, les réchauffeurs H associés à ces filtres. Dans le cas de la figure 3a et de la figure 3c, le laser La produit un rayonnement présentant une pluralité de fréquences d'émission. Dans le cas de la figure 3b, le laser La produit un rayonnement présentant une unique fréquence d'émission. Dans les deux exemples, l'unique photodétecteur PD produit le signal de contrôle V.

Dans le mode de réalisation des figures 3a à 3d, le verrouillage des filtres ou filtres élémentaires MR1,MR2,MR3 sur une fréquence d'émission du laser La sont conduits simultanément, par multiplexage en fréquence. A cet effet, le système comprend une pluralité de modulateurs M1,M2,M3, chaque modulateur produisant un signal de modulation Vd1,Vd2,Vd3, de préférence spectralement pur, présentant donc une unique fréquence de modulation. Cette unique fréquence de modulation est distincte d'un modulateur à un autre, si bien que les fréquences de résonnance des filtres (figures 3a,3b) ou les fréquences d'émission des lasers (figures 3c,3d) sont modulées à l'aide de fréquences de modulation distinctes, ce qui permet de les repérer dans le spectre en raie élaboré par le dispositif de verrouillage R, au cours de la première opération OP1. A titre d'exemple, les fréquences de modulation peuvent être comprises et étagées dans la gamme s'étendant de 1kHz à 30 kHz. Dans le cas de ce mode de réalisation, il n'est donc pas nécessaire que les modulateurs M1,M2,M3 soient commandables par l'intermédiaire d'un signal de sélection temporel. On prendra soin de choisir les fréquences de modulation pour qu'elles soient non seulement distinctes les unes des autres, mais également distinctes de leurs secondes harmoniques afin d'éviter le recouvrement spectral d'une fréquence de modulation et d'une seconde harmonique d'une autre fréquence de modulation. Dans l'exemple représenté sur la figure 3d, le système photonique 1 est muni d'un photodétecteur d'entrée PDin pour mesurer une partie du rayonnement lumineux se propageant sur le guide d'onde WG, en amont des filres optiques MR1,MR2,MR3 et pour produire un signal de référence Vr, fourni au dispositif de verrouillage R.

Le dispositif de verrouillage R peut combiner les informations présentes dans le signal de contrôle V et dans le signal de référence Vr pour élaborer le premier signal de verrouillage Vr1 et/ou le second signal de verrouillage Vr2, comme cela a été expliqué dans un passage précédent.

Les traitements mis en œuvre par la première partie R1 du dispositif de verrouillage R sont naturellement adaptés à ce mode de réalisation, mais reposent sur les principes exposés précédemment. En particulier, l'opération de traitement permet de repérer dans le spectre les raies (fondamentales et harmoniques), de préparer une pluralité de premiers signaux de verrouillage et de les associer respectivement aux filtres. La première partie R1 du dispositif de verrouillage R est également configuré pour mettre en œuvre une pluralité d'opérations, respectivement associées aux signaux de verrouillage, pour produire concurremment une pluralité de commandes d'ajustement CL1,CL2,CL3 des dispositifs d'ajustement H associés aux filtres MR1,MR2,MR3.

### Premier exemple d'application

La figure 4a illustre un exemple d'application d'un dispositif photonique 1 pouvant tirer profit d'un procédé de positionnement spectral conforme à l'invention. Dans cette illustration, la source laser La est constituée d'une banque de lasers La1,La2,La3 émettant chacun un rayonnement présentant une fréquence d'émission F1,F2,F3 distincte des autres lasers. Ces rayonnements sont recombinés par un mélangeur MO produisant une pluralité de rayonnement lumineux, chaque rayonnement combinant les fréquences d'émission F1,F2,F3. L'un de ces rayonnements est exploité, au moins en partie, par couplage à un filtre MR, puis au photodétecteur PD par l'intermédiaire d'un guide d'onde WG. Le filtre MR présente une pluralité de fréquences de résonance F0i,F0j,F0k régulièrement espacées.

Chaque laser La1,La2,La3 est associé à une source de courant respective produisant son courant d'alimentation, chaque source formant un dispositif d'ajustement de la fréquence d'émission d'un laser au sens de l'invention. En modulant ou en ajustant le courant produit par une source de courant, on module ou on ajuste la fréquence du laser associé. Comme on l'a déjà évoqué, le dispositif d'ajustement peut prendre d'autres formes que celui pris ici en exemple.

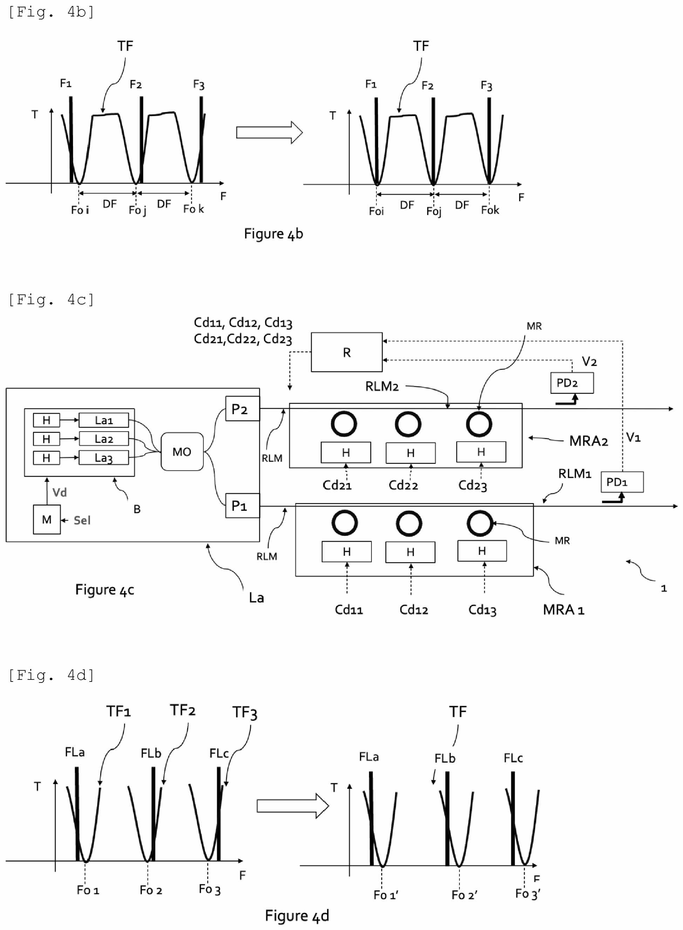

Comme cela est visible sur la partie gauche de la figure 4b, les fréquences d'émissions des lasers de la banque ne sont pas nécessairement uniformément séparées fréquentiellement, et cet écart spectral variable d'une paire de lasers à l'autre peut être problématique. Pour corriger cela et obtenir la configuration représentée sur la partie droite de la figure 4b, on peut munir le dispositif photonique d'un dispositif de verrouillage R mettant en œuvre les opérations constituant le procédé de positionnement spectral de l'invention. Le dispositif de verrouillage R peut opérer indifféremment selon le premier mode de réalisation (par multiplexage temporel) ou selon le second mode de réalisation (par multiplexage en fréquence). Au cours du fonctionnement du système photonique ainsi constitué, les fréquences d'émission des lasers sont ajustées aux fréquences de résonnance du filtre MR, et l'écart spectral est régularisé.

La figure 4c présente une variante du premier exemple d'application. La source laser La présente au moins un port de sortie (deux ports P1, P2 sur la figure 4c) produisant chacun un rayonnement lumineux multispectral RLM. Ce rayonnement est donc composé spectralement d'une pluralité de raies séparées d'un intervalle spectral qui peut être variable. Une au moins de ces raies est modulée en fréquence, comme cela a été exposé en détail en relation avec l'exposé des figures 2c et 3c.

Chaque laser La1,La2,La3 est associé à une source de courant H, formant des moyens d'ajustement de sa fréquence d'émission, reliée au modulateur M. Les lasers La,Lb,Lc sont couplés à un mélangeur optique MO par l'intermédiaire d'un réseau de guides d'onde internes à la source La. Le rayonnement lumineux multispectral RLM produit par le mélangeur optique MO est guidé par le réseau de guides d'onde interne sur un port P1, P2 de la source La. Il se propage dans un guide d'onde externe couplé à ce port P1, P2.

Le guide d'onde externe est lui-même couplé à un composant photonique MRA1, MRA2, disposé donc optiquement en aval de la source La, sur le port P1,P2 du composant, le composant photonique comprenant une pluralité de filtres optiques MR présentant, respectivement, des fréquences de résonnance accordables individuellement.

Dans l'exemple représenté sur la figure 4c, deux modulateurs radiofréquences MRA1,MRA2 mettant en œuvre chacun un réseau de micro résonateurs, sont respectivement optiquement reliés aux deux ports P1,P2 de la source laser La. Comme cela est bien connu en soi dans le domaine des télécommunications, un modulateur radiofréquence permet de conditionner chaque raie spectrale du rayonnement lumineux multispectral (ici à l'aide de micro résonateurs respectivement accordés à ces raies) pour transmettre de manière multiplexée en fréquence des signaux d'information. Mais cet aspect de l'invention n'est nullement limité à des composants photoniques mettant en œuvre un modulateur radiofréquence, et s'applique à tout composant photonique présentant une pluralité de filtres optiques qu'il peut être avantageux de verrouiller sur des fréquences d'un rayonnement lumineux.

Pour permettre le verrouillage du système photonique S, les résonateurs MR du réseau de résonateurs des modulateurs radiofréquences MRA1, MRA2 sont respectivement associés à des réchauffeurs H, formant les dispositifs d'ajustement permettant d'ajuster leur fréquence de résonnance, notamment pour les verrouiller sur les raies spectrales auxquelles ils sont associés. On peut de la sorte accorder le composant optique MRA1,MRA2 à la source La. On a également prévu un unique photodétecteur de surveillance PD1, PD2 optiquement en aval du composant photonique MRA1,MRA2 afin d'établir un signal électrique V1,V2 représentatif du rayonnement multispectral RLM1,RLM2 produit par ce composant. On peut à cet effet prélever une petite partie au moins de ce rayonnement multispectral RLM1,RLM2 et coupler cette partie prélevée au photodétecteur de surveillance PD1, PD2.

Un dispositif de verrouillage R recueille le signal V1, V2 fourni par le photodétecteur de surveillance PD1, PD2 et produit les signaux de commande Cd11,Cd12,Cd13 ; Cd21,Cd22,Cd23 permettant de contrôler les dispositif d'ajustements H des filtres optiques MR composant le composant photonique MRA1,MRA2, et donc d'ajuster individuellement leurs fréquences de résonnance pour les verrouiller sur les fréquences d'émission de la source La.

Dans le système photonique 1 comprenant un modulateur radiofréquence, on cherche à positionner la fréquence de résonance F01,F02,F03 de chaque micro résonateur MR relativement à une raie spectrale FLa,FLb,FLc du rayonnement multispectral produit par la source La, selon la configuration de la figure 1a, c'est-à-dire dans une partie linéaire de la fonction de transfert TF1-TF3 du micro résonateur MR. On recherche bien entendu à allouer une raie d'émission distincte à chaque micro résonateur. Comme cela est illustré sur la figure 4d, on exploite les moyens d'ajustement H associés aux micro résonateurs MR pour ajuster les fréquences de résonance originelles F01,F02,F03 vers ces fréquences optimisées F01',F02',F03'.

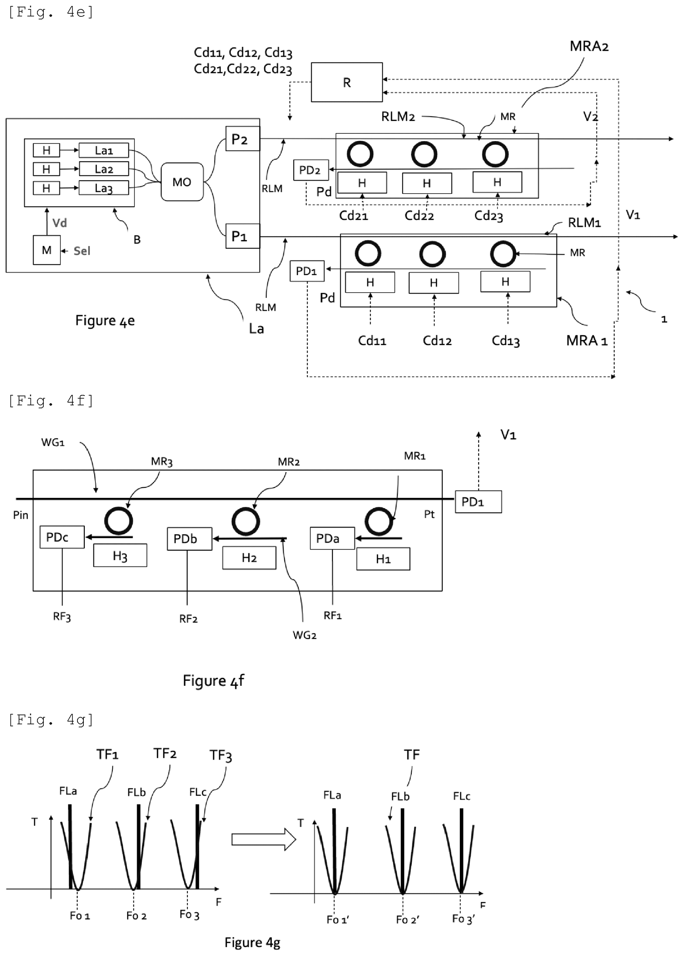

La figure 4e représente une autre variante de l'exemple représenté sur la figure 4c. Dans cette variante, le modulateur présente un port de sortie de perte Pd (« drop port » selon la dénomination anglo-saxonne). Le photodétecteur de surveillance PD1, PD2 est directement couplé au port de sortie de perte Pd.

La figure 4f présente un démodulateur, ce démodulateur formant un autre type de composant optique MR1,MRA2 pouvant être calibré/verrouillé conformément aux principes de l'invention. Dans un tel démodulateur, chaque micro résonateur du réseau de micro résonateurs en anneau MR1-MR3 est disposé entre un premier et un second guide d'onde WG1,WG2. Le premier guide d'onde WG1 présente un port d'entrée Pin sur lequel peut être fourni le rayonnement lumineux multispectral à démoduler et un port de transmission Pt. Les ports de perte des micro résonateurs MR1,MR2,MR3 sont connectés à des photodétecteurs de démodulation PDa, PDb, PDc. Le photodétecteur PD1 est placé sur le premier guide d'onde WG1, au niveau du port de transmission Pt. Chaque micro résonateur MR1-MR3 permet de filtrer et d'extraire du rayonnement lumineux multispectral des signaux radiofréquences RF1,RF2,RF3 respectivement portés par les fréquences d'émission (plutôt désignés « fréquences porteuses » dans ce contexte) FLa,FLb,FLc du rayonnement lumineux multispectral. On retrouve également un moyen d'ajustement H1-H3 de la fréquence de résonance F01-F03, par exemple un réchauffeur, associé à chaque micro résonateur MR1-MR3

En figure 4g on a représenté, à gauche de cette figure, le positionnement relatif des fréquences de résonance F01,F02,F03 des filtres MR1,MR2,MR3 et des fréquences porteuses FLa,FLb,FLc, avant ajustement. On a également représenté, à droite de cette figure 4g, le positionnement relatif des fréquences de résonance ajustée F01',F02',F03' et des fréquences porteuses FLa,FLb,FLc, après ajustement et dans le cas où, volontairement, il est choisi de verrouiller les micro-résonateur MR1,MR2,MR3 sur les porteuses optiques les plus proches FLa,FLb,FLc.

Bien entendu, on peut prévoir de munir le système photonique 1 d'un photodétecteur d'entrée PDin1,PDin2 associé à chaque guide d'onde externe en amont du dispositif photonique MRA1,MRA2, comme cela a été présenté dans les schémas de principes des figures 2d,3d. Cette variante est représentée sur la figure 4h.

Chaque photodétecteur d'entrée PDin1,PDin2 produit un signal de référence Vr,Vr' qui peut être exploité par le dispositif de verrouillage R, comme cela a été exposé dans un paragraphe précédent de cette description.

Le dispositif de verrouillage R des variantes représentés sur les figures 4c, 4e et 4f est exploité en multiplexage temporel. On peut également exploiter cette variante en multiplexage fréquentiel, des modulateurs générant alors simultanément une pluralité de signaux de modulation distincts les uns des autres comme cela a été présenté en relation avec la description de la figure 3c.

Quelle que soit la nature du ou des composants photoniques MRA1,MRA2 associée à la source La, il peut être avantageux d'engager la mise en œuvre du système, au cours d'une phase de démarrage, dans un fonctionnement en multiplexage fréquentiel dans lequel une fréquence de modulation distincte est appliquée sur chaque fréquence d'émission/porteuse Fla,Flb,FLc du rayonnement lumineux multispectral RLM. Par simplicité de mise en œuvre, on peut choisir de produire les uns à la suite des autres, pour ajuster la fréquence de résonance d'un filtre optique à la fois, les signaux de commande permettant de contrôler indépendamment les dispositifs d'ajustement H de chaque micro résonateur MR1,MR2,MR3. Comme on l'a déjà énoncé, ce mode de mis en œuvre permet de maitriser l'association d'un micro résonateur à une fréquence porteuse, là où les solutions de l'état de la technique pouvaient conduire à associer plusieurs micro-résonateurs à une même fréquence porteuse. Une fois cette phase de démarrage réalisée, on peut choisir de produire les signaux de commande concurremment.

### Deuxième exemple d'application

La figure 5a représente un autre dispositif photonique pouvant tirer profit d'un procédé de positionnement spectral conforme à l'invention. Sur cette figure, ce dispositif est constitué d'un laser accordable comprenant une zone de gain G et une zone de phase P. La zone de phase P peut être constituée par exemple par un réchauffeur d'une section de guide d'onde, et la zone de gain G est alimentée en courant, comme cela est bien connu en soi afin de provoquer l'émission d'un rayonnement lumineux guidé par au moins un guide d'onde WG1,WG2 entre deux réflecteurs PR définissant une cavité, ces réflecteurs étant partiaux et laissant passer une partie de ce rayonnement, par exemple de l'ordre de 90%. Dans cette cavité optique, on a positionné deux filtres élémentaires MR1,MR2, chacun de ces filtres étant associé à un dispositif d'ajustement de fréquence H1,H2, par exemple un réchauffeur. Ces filtres élémentaires permettent de sélectionner avec précision une des fréquences d'émission de la cavité laser (les fréquences d'émission de la cavité laser étant couramment dénommés « modes » de la cavité), en ajustant chacune des fréquences de résonnance des filtres élémentaires sur le mode choisi de la fréquence d'émission du laser.

On peut munir le dispositif photonique de la figure 5a d'un dispositif de verrouillage R mettant en œuvre les deux modes de fonctionnement (ou l'un au moins de ces modes de fonctionnement) constituant le procédé de positionnement spectral de l'invention. Le dispositif de verrouillage R peut opérer indifféremment dans le premier mode de fonctionnement selon le premier mode de mis en œuvre (par multiplexage temporel) ou selon le second mode de mis en œuvre (par multiplexage en fréquence). Au cours du fonctionnement du système photonique ainsi constitué, les fréquences de résonnance des filtres élémentaires MR1,MR2 sont chacune verrouillées sur la fréquence d'émission CM (modes de la cavité) choisie du laser définissant son mode d'émission, comme cela est représenté sur la figure 5b.

### Troisième exemple d'application

La figure 6a représente encore un autre dispositif photonique pouvant tirer profit d'un procédé de positionnement spectral conforme à l'invention. Sur cette figure, un routeur photonique comprend une source laser, représentée ici un par un coupleur d'entrée GCin permettant de recevoir un rayonnement lumineux émis par un laser extérieur au dispositif. Le rayonnement lumineux reçu est guidé par un guide d'onde WG vers un photodétecteur PD. Le long du guide d'onde WG, une pluralité de filtres MR1,MR2,MR3 sont disposés entre ce guide d'onde et des coupleurs de sorties GC1out, GC2out,GC3out. Chaque filtre est associé à un dispositif d'ajustement H1,H2,H3, par exemple un réchauffeur.

En fonctionnement, le dispositif photonique permet d'adresser le rayonnement lumineux reçu sur le coupleur d'entrée vers un coupleur de sortie choisi. Pour permettre ce choix, on verrouille à l'aide du dispositif d'ajustement la fréquence de résonnance du filtre associé au coupleur de sortie choisi à la fréquence d'émission du rayonnement laser. Dans le même temps, on désaligne les fréquences de résonnance des autres filtres associés aux coupleurs de sortie non choisie de la fréquence d'émission de la source laser. Ce fonctionnement est représenté sur la figure 6b, sur laquelle et à titre d'exemple, le rayonnement lumineux est guidé vers un des coupleurs de sortie GC3out en verrouillant la fréquence d'émission Fla à la fréquence de résonnance du filtre MR3 associé au coupleur de sortie GC3out choisi. Simultanément, les deux autres filtres MR1,MR2 sont désalignés de la fréquence d'émission Fla du laser. De la sorte le rayonnement lumineux se propageant dans le guide d'onde WG est couplé à l'unique coupleur de sortie choisi.

On peut munir le dispositif photonique de la figure 6a d'un dispositif de verrouillage R conforme à l'invention. Le dispositif de verrouillage R peut opérer indifféremment dans le premier mode de fonctionnement selon le premier mode de mis en œuvre (par multiplexage temporel) ou selon le second mode de mis en œuvre (par multiplexage en fréquence). Au cours du fonctionnement du système photonique ainsi constitué, la fréquence de résonnance du filtre associé au coupleur de sortie choisi est verrouillée sur la fréquence d'émission du laser, et les autres filtres sont au contraire désalignés.

Bien entendu l'invention n'est pas limitée aux modes de mise en œuvre décrits et on peut y apporter des variantes de réalisation sans sortir du cadre de l'invention tel que défini par les revendications.

Notamment, bien que l'on ait pris dans les exemples des filtres se présentant sous la forme d'anneaux résonnants, cela ne forme nullement une limitation de l'invention qui trouve son application pour n'importe quelle forme de filtre, par exemple un filtre de type interféromètre de Mach Zehnder (MZ). Ce filtre peut former, en partie au moins, un modulateur, par exemple un modulateur en anneau résonnant ou un modulateur MZ.

Par ailleurs, le guide d'onde peut être une fibre optique et le laser peut être modulé, par exemple un laser externe dont on module l'intensité.

## Revendications

1. Procédé de positionnement spectral d'un système photonique, le système photonique (1) comprenant
- au moins une source laser (La;La1,La2,La3) produisant un rayonnement présentant une fréquence d'émission ;
- au moins un filtre (MR;MR1,MR2,MR3) présentant une fréquence de résonnance ;
- au moins un guide d'onde (WG ;WG1,WG2) configuré pour coupler optiquement le rayonnement produit par la source laser (La;La1,La2,La3) au filtre (MR;MR1,MR2,MR3) ;
- un photodétecteur (PD ;PD1,PD2) optiquement couplé au guide d'onde (WG;WG1,WG2) pour recevoir un rayonnement filtré, le photodétecteur (PD;PD1,PD2) produisant un signal de contrôle (V;V1,V2) ;
- au moins un dispositif d'ajustement (H) associé à la source laser (La ;La1,La2,La3) et/ou au filtre (MR;MR1,MR2,MR3), le dispositif d'ajustement (H) étant commandé d'une part pour moduler, à une fréquence de modulation (Fd), la fréquence d'émission de la source laser ou la fréquence de résonnance du filtre et, d'autre part, pour ajuster la fréquence d'émission de la source laser (La;La1,La2,La3) ou la fréquence de résonnance du filtre (MR;MR1,MR2,MR3) ;
le procédé mettant en œuvre les opérations suivantes :
- le conditionnement du signal de contrôle (V;V1, V2) conduisant à produire un signal numérique de contrôle (Vn);
- une première opération (OP1) de traitement du signal numérique de contrôle (Vn) pour produire :
o un premier signal de verrouillage (Vr1), représentatif de la puissance d'une deuxième harmonique et/ou d'une composante principale de la fréquence de modulation (Fd) présente dans le signal numérique de contrôle (Vn), et
o au moins un deuxième signal de verrouillage (Vr2) représentatif de la phase d'une composante principale de la fréquence de modulation (Fd) présente dans le signal numérique de contrôle (Vn);
- une deuxième opération (OP2) de traitement du premier signal de verrouillage (Vr1) pour optimiser l'amplitude du premier signal de verrouillage (Vr1) et/ou du deuxième signal de verrouillage (Vr2) pour déterminer la position relative de la fréquence d'émission et de la fréquence de résonnance du filtre, la deuxième opération produisant une commande numérique d'ajustement (CLan) ;
- le conditionnement de la commande numérique d'ajustement (CLan) pour produire la commande d'ajustement (CLa;CLa1,CLa2,CLa3) et l'appliquer au dispositif d'ajustement (H).

2. Procédé selon la revendication 1 comprenant
- une première phase de positionnement spectral au cours de laquelle la deuxième opération (OP2) traite uniquement le second signal de verrouillage (Vr2) pour produire la commande numérique d'ajustement (CLan), puis ;
- une seconde phase de positionnement spectrale au cours de laquelle la deuxième opération (OP2) traite le premier signal de verrouillage et/ou le second signal de verrouillage (Vr2) pour produire la commande numérique d'ajustement (CLan).

3. Procédé selon l'une des revendications précédentes dans lequel le premier signal de verrouillage (Vr1) est représentatif de la puissance d'une deuxième harmonique de la fréquence de modulation (Fd) et la deuxième opération (OP2) vise à maximiser l'amplitude du premier signal de verrouillage (Vr1), ou le premier signal de verrouillage (Vr1) est représentatif de la puissance de la composante principale de la fréquence de modulation (Fd) et la deuxième opération (OP2) vise à minimiser l'amplitude du premier signal de verrouillage (Vr1).

4. Procédé selon l'une des revendications précédentes dans lequel le premier signal de verrouillage (Vr1) est formé du rapport entre la puissance de la deuxième harmonique de la fréquence de modulation (Fd) et la puissance de la composante principale de la fréquence de modulation (Fd), la deuxième opération (OP2) visant à optimiser l'amplitude du premier signal de verrouillage (Vr1) pour qu'il soit égal ou supérieur à une valeur déterminée.

5. Procédé selon l'une des revendications précédentes dans lequel le deuxième signal de verrouillage (Vr2) correspond à la différence entre la phase d'une composante principale de la fréquence de modulation (Fd) présente dans le signal numérique de contrôle (Vn) et la phase d'un signal de modulation ou d'un signal de référence (Vr).

6. Procédé selon la revendication précédente dans lequel le signal de référence (Vr) est produit par un photodétecteur d'entrée (PDin) disposé en amont du filtre optique (MR1,MR2,MR3) pour mesurer une partie du rayonnement lumineux se propageant sur le guide d'onde (WG).

7. Procédé selon l'une des revendications précédentes dans lequel le système photonique (1) comprend une pluralité de dispositifs d'ajustement (H) respectivement associés à une pluralité de sources laser (La1,La2,La3) ou à une pluralité de filtres (MR1,MR2,MR3).

8. Procédé selon la revendication précédente comprenant une étape de sélection d'un seul des dispositifs d'ajustement (H), l'étape de sélection étant répétée pour sélectionner successivement chacun des dispositifs d'ajustement (H).

9. Procédé selon la revendication 7 dans lequel les fréquences de modulation des dispositifs d'ajustement (H) sont distinctes les unes des autres.

10. Système photonique (1) de positionnement spectral d'un dispositif photonique comprenant :
- au moins une source laser (La;La1,La2,La3) produisant un rayonnement présentant au moins une fréquence d'émission ;
- au moins un filtre (MR;MR1,MR2,MR3) présentant une fréquence de résonnance ;
- au moins un guide d'onde (WG;WG1,WG2) configuré pour coupler optiquement le rayonnement produit par la source laser (La;La1,La2,La3) au filtre (MR;MR1,MR2,MR3) ;
- un photodétecteur (PD) optiquement couplé au guide d'onde (WG;WG1,WG2) pour recevoir un rayonnement filtré, le photodétecteur (PD) produisant un signal de contrôle (V) ;
- au moins un dispositif d'ajustement (H) associé à la source laser (La;La1,La2,La3) et/ou au filtre (MR;MR1,MR2,MR3), le dispositif d'ajustement (H) étant commandé pour d'une part moduler, à une fréquence de modulation (Fd),la fréquence d'émission de la source laser ou la fréquence de résonnance du filtre et, d'autre part, pour ajuster la fréquence d'émission de la source laser (La;La1,La2,La3) ou la fréquence de résonnance du filtre (MR;MR1,MR2,MR3);
- un dispositif de verrouillage (R) configuré pour mettre en œuvre les opérations suivantes :
i. le conditionnement du signal de contrôle (V) conduisant à produire un signal numérique de contrôle (Vn) ;
ii. une première opération (OP1) de traitement du signal numérique de contrôle (Vn) pour produire :
o au moins un premier signal de verrouillage (Vr1) représentatif de la puissance d'une deuxième harmonique et/ou d'une composante principale de la fréquence de modulation (Fd) présente dans le signal numérique de contrôle (Vn) ; et
o au moins un deuxième signal de verrouillage (Vr2) représentatif de la phase d'une composante principale de la fréquence de modulation (Fd) présente dans le signal numérique de contrôle (Vn);
iii. une deuxième opération (OP2) de traitement du premier signal de verrouillage (Vr1) pour optimiser l'amplitude du premier signal de verrouillage (Vr1) et/ou du deuxième signal de verrouillage (Vr2) pour déterminer la position relative de la fréquence d'émission et de la fréquence de résonnance du filtre, la deuxième opération produisant une commande numérique d'ajustement (CLan) ;
iv. le conditionnement de la commande numérique d'ajustement (CLan) pour produire la commande d'ajustement (CLa;CLa1,CLa2,CLa3) et l'appliquer au dispositif d'ajustement (H).

11. Système photonique (1) selon la revendication précédente comprenant un unique photodétecteur (PD,PD1,PD2) couplé à un guide d'onde (WG;WG1,WG2) en aval du filtre.

12. Système photonique (1) selon la revendication 10 ou 11 comprenant en outre un photodétecteur d'entrée (PDin;PDin1,PDin2) couplé au guide d'onde (WG;WG1,WG2) en amont du filtre (MR;MR1,MR2,MR3).

13. Système photonique (1) selon l'une des revendications 10 à 12 dans lequel le dispositif photonique est un laser accordable.

14. Système photonique (1) selon l'une des revendications 10 à 12 dans lequel le dispositif photonique est un routeur optique.

15. Système photonique (1) selon l'une des revendications 10 à 12 dans lequel la source laser comprend une pluralité de lasers (La1,La2,La3) émettant une pluralité de fréquences d'émission.

16. Système photonique (1) selon la revendication précédente dans lequel des dispositifs d'ajustement (H) associés aux lasers (La1,La2,La3) de la source sont commandés pour moduler les fréquences d'émission de la source et au moins un dispositif d'ajustement(H) associé au filtre (MR;MR1,MR2,MR3) est commandé pour ajuster la fréquence de résonnance du filtre (MR;MR1,MR2,MR3) .

## Patentansprüche

1. Verfahren zur spektralen Positionierung eines photonischen Systems, wobei das photonische System (1) umfasst
- mindestens eine Laserquelle (La;La1,La2,La3), die eine Strahlung mit einer Emissionsfrequenz erzeugt;
- mindestens einen Filter (MR;MR1,MR2,MR3), der eine Resonanzfrequenz aufweist;
- mindestens einen Wellenleiter (WG;WG1,WG2), der konfiguriert ist, um die von der Laserquelle (La;La1,La2,La3) erzeugte Strahlung optisch mit dem Filter (MR;MR1,MR2,MR3) zu koppeln;
- einen Photodetektor (PD; PD1, PD2), der optisch mit dem Wellenleiter (WG; WG1, WG2) gekoppelt ist, um gefilterte Strahlung zu empfangen, wobei der Photodetektor (PD; PD1, PD2) ein Steuersignal (V; V1, V2) erzeugt;
- mindestens eine Einstellvorrichtung (H), die der Laserquelle (La; La1,La2,La3) und/oder dem Filter (MR;MR1,MR2,MR3) zugeordnet ist, wobei die Einstellvorrichtung (H) gesteuert wird, um einerseits mit einer Modulationsfrequenz (Fd) die Emissionsfrequenz der Laserquelle oder die Resonanzfrequenz des Filters zu modulieren und andererseits die Emissionsfrequenz der Laserquelle (La;La1,La2,La3) oder die Resonanzfrequenz des Filters (MR;MR1,MR2,MR3) einzustellen;
wobei das Verfahren die folgenden Operationen durchführt:
- das Aufbereiten des Steuersignals (V;V1,V2), das zur Erzeugung eines digitalen Steuersignals (Vn) führt;
- eine erste Operation (OP1) zur Verarbeitung des digitalen Steuersignals (Vn), um Folgendes zu erzeugen:
∘ ein erstes Verriegelungssignal (Vr1), das für die Leistung einer zweiten Harmonischen und/oder einer Hauptkomponente der Modulationsfrequenz (Fd) repräsentativ ist, die in dem digitalen Steuersignal (Vn) vorhanden ist, und
∘ mindestens ein zweites Verriegelungssignal (Vr2), das für die Phase einer Hauptkomponente der Modulationsfrequenz (Fd) repräsentativ ist, die in dem digitalen Steuersignal (Vn) vorhanden ist;
- eine zweite Operation (OP2) zur Verarbeitung des ersten Verriegelungssignals (Vr1), um die Amplitude des ersten Verriegelungssignals (Vr1) und/oder des zweiten Verriegelungssignals (Vr2) zu optimieren, um die relative Position der Emissionsfrequenz und der Resonanzfrequenz des Filters zu bestimmen, wobei die zweite Operation einen digitalen Einstellbefehl (CLan) erzeugt;
- das Aufbereiten des digitalen Einstellbefehls (CLan), um den Einstellbefehl (CLa;CLa1,CLa2,CLa3) zu erzeugen und auf die Einstellvorrichtung (H) anzuwenden.

2. Verfahren nach Anspruch 1, umfassend:
- eine erste spektrale Positionierungsphase, während der die zweite Operation (OP2) ausschließlich das zweite Verriegelungssignal (Vr2) verarbeitet, um den digitalen Einstellbefehl (CLan) zu erzeugen, anschließend;
- eine zweite spektrale Positionierungsphase, während der die zweite Operation (OP2) das erste Verriegelungssignal und/oder das zweite Verriegelungssignal (Vr2) verarbeitet, um den digitalen Einstellbefehl (CLan) zu erzeugen.

3. Verfahren nach einem der vorstehenden Ansprüche, wobei das erste Verriegelungssignal (Vr1) repräsentativ für die Leistung einer zweiten Harmonischen der Modulationsfrequenz (Fd) ist und die zweite Operation (OP2) darauf abzielt, die Amplitude des ersten Verriegelungssignals (Vr1) zu maximieren, oder das erste Verriegelungssignal (Vr1) repräsentativ für die Leistung der Hauptkomponente der Modulationsfrequenz (Fd) ist und die zweite Operation (OP2) darauf abzielt, die Amplitude des ersten Verriegelungssignals (Vr1) zu minimieren.

4. Verfahren nach einem der vorstehenden Ansprüche, wobei das erste Verriegelungssignal (Vr1) aus dem Verhältnis zwischen der Leistung der zweiten Harmonischen der Modulationsfrequenz (Fd) und der Leistung der Hauptkomponente der Modulationsfrequenz (Fd) gebildet wird, wobei die zweite Operation (OP2) darauf abzielt, die Amplitude des ersten Verriegelungssignals (Vr1) derart zu optimieren, dass es gleich oder größer als ein bestimmter Wert ist.

5. Verfahren nach einem der vorstehenden Ansprüche, wobei das zweite Verriegelungssignal (Vr2) der Differenz zwischen der Phase einer Hauptkomponente der Modulationsfrequenz (Fd), die in dem digitalen Steuersignal (Vn) vorhanden ist, und der Phase eines Modulationssignals oder eines Referenzsignals (Vr) entspricht.

6. Verfahren nach dem vorstehenden Anspruch, wobei das Referenzsignal (Vr) durch einen Eingangsphotodetektor (PDin) erzeugt wird, der stromaufwärtig des optischen Filters (MR1, MR2, MR3) angeordnet ist, um einen Teil der Lichtstrahlung zu messen, die sich entlang des Wellenleiters (WG) ausbreitet.

7. Verfahren nach einem der vorstehenden Ansprüche, wobei das photonische System (1) eine Vielzahl von Einstellvorrichtungen (H) umfasst, die jeweils einer Vielzahl von Laserquellen (La1, La2, La3) oder einer Vielzahl von Filtern (MR1, MR2, MR3) zugeordnet sind.

8. Verfahren nach dem vorstehenden Anspruch, umfassend einen Schritt des Auswählens einer einzigen der Einstellvorrichtungen (H), wobei der Schritt des Auswählens wiederholt wird, um nacheinander jede der Einstellvorrichtungen (H) auszuwählen.

9. Verfahren nach Anspruch 7, wobei die Modulationsfrequenzen der Einstellvorrichtungen (H) voneinander verschieden sind.

10. Photonisches System (1) zur spektralen Positionierung einer photonischen Vorrichtung, umfassend:
- mindestens eine Laserquelle (La;La1,La2,La3), die eine Strahlung mit mindestens einer Emissionsfrequenz erzeugt;
- mindestens einen Filter (MR;MR1,MR2,MR3), der eine Resonanzfrequenz aufweist;
- mindestens einen Wellenleiter (WG;WG1,WG2), der konfiguriert ist, um die von der Laserquelle (La;La1,La2,La3) erzeugte Strahlung optisch mit dem Filter (MR;MR1,MR2,MR3) zu koppeln;
- einen Photodetektor (PD), der optisch mit dem Wellenleiter (WG; WG1, WG2) gekoppelt ist, um gefilterte Strahlung zu empfangen, wobei der Photodetektor (PD) ein Steuersignal (V) erzeugt;
- mindestens eine Einstellvorrichtung (H), die der Laserquelle (La; La1,La2,La3) und/oder dem Filter (MR;MR1,MR2,MR3) zugeordnet ist, wobei die Einstellvorrichtung (H) gesteuert wird, um einerseits mit einer Modulationsfrequenz (Fd) die Emissionsfrequenz der Laserquelle oder die Resonanzfrequenz des Filters zu modulieren und andererseits die Emissionsfrequenz der Laserquelle (La;La1,La2,La3) oder die Resonanzfrequenz des Filters (MR;MR1,MR2,MR3) einzustellen;
- eine Verriegelungsvorrichtung (R), die konfiguriert ist, um die folgenden Operationen durchzuführen:
i. das Aufbereiten des Steuersignals (V), das zur Erzeugung eines digitalen Steuersignals (Vn) führt;
ii. eine erste Operation (OP1) zur Verarbeitung des digitalen Steuersignals (Vn), um Folgendes zu erzeugen:
∘ mindestens ein erstes Verriegelungssignal (Vr1), das für die Leistung einer zweiten Harmonischen und/oder einer Hauptkomponente der Modulationsfrequenz (Fd) repräsentativ ist, die in dem digitalen Steuersignal (Vn) vorhanden ist; und
∘ mindestens ein zweites Verriegelungssignal (Vr2), das für die Phase einer Hauptkomponente der Modulationsfrequenz (Fd) repräsentativ ist, die in dem digitalen Steuersignal (Vn) vorhanden ist;
iii. eine zweite Operation (OP2) zur Verarbeitung des ersten Verriegelungssignals (Vr1), um die Amplitude des ersten Verriegelungssignals (Vr1) und/oder des zweiten Verriegelungssignals (Vr2) zu optimieren, um die relative Position der Emissionsfrequenz und der Resonanzfrequenz des Filters zu bestimmen, wobei die zweite Operation einen digitalen Einstellbefehl (CLan) erzeugt;
iv. das Aufbereiten des digitalen Einstellbefehls (CLan), um den Einstellbefehl (CLa;CLa1,CLa2,CLa3) zu erzeugen und auf die Einstellvorrichtung (H) anzuwenden.

11. Photonisches System (1) nach dem vorstehenden Anspruch, umfassend einen einzigen Photodetektor (PD,PD1,PD2), der stromabwärtig des Filters an einen Wellenleiter (WG;WG1,WG2) gekoppelt ist.

12. Photonisches System (1) nach Anspruch 10 oder 11, ferner umfassend einen Eingangsphotodetektor (PDin;PDin1,PDin2), der mit dem Wellenleiter (WG;WG1,WG2) stromaufwärtig des Filters (MR;MR1,MR2,MR3) gekoppelt ist.

13. Photonisches System (1) nach einem der Ansprüche 10 bis 12, wobei die photonische Vorrichtung ein abstimmbarer Laser ist.

14. Photonisches System (1) nach einem der Ansprüche 10 bis 12, wobei die photonische Vorrichtung ein optischer Router ist.

15. Photonisches System (1) nach einem der Ansprüche 10 bis 12, wobei die Laserquelle eine Vielzahl von Lasern (La1,La2,La3) umfasst, die eine Vielzahl von Emissionsfrequenzen emittieren.

16. Photonisches System (1) nach dem vorstehenden Anspruch, wobei Einstellvorrichtungen (H), die den Lasern (La1, La2, La3) der Quelle zugeordnet sind, gesteuert werden, um die Emissionsfrequenzen der Quelle zu modulieren, und mindestens eine Einstellvorrichtung (H), die dem Filter (MR; MR1, MR2, MR3) zugeordnet ist, gesteuert wird, um die Resonanzfrequenz des Filter (MR; MR1, MR2, MR3) einzustellen.

## Claims

1. A method for spectral positioning of a photonic system, the photonic system (1) comprising
- at least one laser source (La; La1, La2, La3) producing radiation having an emission frequency;
- at least one filter (MR; MR1, MR2, MR3) having a resonant frequency;
- at least one waveguide (WG; WG1, WG2) configured to optically couple the radiation produced by the laser source (La; La1, La2, La3) to the filter (MR; MR1, MR2, MR3);
- a photodetector (PD; PD1, PD2) optically coupled to the waveguide (WG; WG1, WG2) for receiving filtered radiation, the photodetector (PD; PD1, PD2) producing a control signal (V; V1, V2);
- at least one adjustment device (H) associated with the laser source (La; La1, La2, La3) and/or with the filter (MR; MR1, MR2, MR3), the adjustment device (H) being controlled both to modulate, at a modulation frequency (Fd), the emission frequency of the laser source or the resonant frequency of the filter and to adjust the emission frequency of the laser source (La; La1, La2, La3) or the resonant frequency of the filter (MR; MR1, MR2, MR3);
the method implementing the following operations:
- conditioning the control signal (V; V1, V2) to produce a digital control signal (Vn);
- a first operation (OP1) of processing the digital control signal (Vn) to produce:
∘ a first locking signal (Vr1) representative of the power of a second harmonic and/or of a main component of the modulation frequency (Fd) present in the digital control signal (Vn), and
∘ at least one second locking signal (Vr2) representative of the phase of a main component of the modulation frequency (Fd) present in the digital control signal (Vn);
- a second operation (OP2) of processing the first locking signal (Vr1) to optimize the amplitude of the first locking signal (Vr1) and/or of the second locking signal (Vr2) to determine the relative position of the emission frequency and of the resonant frequency of the filter, the second operation producing a digital adjustment command (CLan);
- conditioning the digital adjustment command (CLan) to produce the adjustment command (CLa; CLa1, CLa2, CLa3) and apply it to the adjustment device (H).

2. The method according to claim 1, comprising
- a first phase of spectral positioning during which the second operation (OP2) only processes the second locking signal (Vr2) to produce the digital adjustment command (CLan), then;
- a second phase of spectral positioning during which the second operation (OP2) processes the first locking signal and/or the second locking signal (Vr2) to produce the digital adjustment command (CLan).

3. The method according to any of the preceding claims, wherein the first locking signal (Vr1) is representative of the power of a second harmonic of the modulation frequency (Fd) and the second operation (OP2) aims to maximize the amplitude of the first locking signal (Vr1), or the first locking signal (Vr1) is representative of the power of the main component of the modulation frequency (Fd) and the second operation (OP2) aims to minimize the amplitude of the first locking signal (Vr1).

4. The method according to any of the preceding claims, wherein the first locking signal (Vr1) is formed by the ratio between the power of the second harmonic of the modulation frequency (Fd) and the power of the main component of the modulation frequency (Fd), the second operation (OP2) aiming to optimize the amplitude of the first locking signal (Vr1) so that it is equal to or greater than a determined value.

5. The method according to any of the preceding claims, wherein the second locking signal (Vr2) corresponds to the difference between the phase of a main component of the modulation frequency (Fd) present in the digital control signal (Vn) and the phase of a modulation signal or of a reference signal (Vr).

6. The method according to the preceding claim, wherein the reference signal (Vr) is produced by an input photodetector (PDin) arranged upstream of the optical filter (MR1, MR2, MR3) to measure a portion of the light radiation propagating along the waveguide (WG).

7. The method according to any of the preceding claims, wherein the photonic system (1) comprises a plurality of adjustment devices (H) respectively associated with a plurality of laser sources (La1, La2, La3) or with a plurality of filters (MR1, MR2, MR3).

8. The method according to the preceding claim, comprising a step of selecting a single one of the adjustment devices (H), the step of selecting being repeated to successively select each of the adjustment devices (H).

9. The method according to claim 7, wherein the modulation frequencies of the adjustment devices (H) are distinct from one another.

10. A photonic system (1) for spectral positioning of a photonic device, comprising:
- at least one laser source (La; La1, La2, La3) producing radiation having at least one emission frequency;
- at least one filter (MR; MR1, MR2, MR3) having a resonant frequency;
- at least one waveguide (WG; WG1, WG2) configured to optically couple the radiation produced by the laser source (La; La1, La2, La3) to the filter (MR; MR1, MR2, MR3);
- a photodetector (PD) optically coupled to the waveguide (WG; WG1, WG2) for receiving filtered radiation, the photodetector (PD) producing a control signal (V);
- at least one adjustment device (H) associated with the laser source (La; La1, La2, La3) and/or with the filter (MR; MR1, MR2, MR3), the adjustment device (H) being controlled both to modulate, at a modulation frequency (Fd), the emission frequency of the laser source or the resonant frequency of the filter and to adjust the emission frequency of the laser source (La; La1, La2, La3) or the resonant frequency of the filter (MR; MR1, MR2, MR3);
- a locking device (R) configured to carry out the following operations:
i. conditioning the control signal (V) to produce a digital control signal (Vn);
ii. a first operation (OP1) of processing the digital control signal (Vn) to produce:
∘ at least one first locking signal (Vr1) representative of the power of a second harmonic and/or of a main component of the modulation frequency (Fd) present in the digital control signal (Vn); and
∘ at least one second locking signal (Vr2) representative of the phase of a main component of the modulation frequency (Fd) present in the digital control signal (Vn);
iii. a second operation (OP2) of processing the first locking signal (Vr1) to optimize the amplitude of the first locking signal (Vr1) and/or of the second locking signal (Vr2) to determine the relative position of the emission frequency and of the resonant frequency of the filter, the second operation producing a digital adjustment command (CLan);
iv. conditioning the digital adjustment command (CLan) to produce the adjustment command (CLa; CLa1, CLa2, CLa3) and apply it to the adjustment device (H).

11. The photonic system (1) according to the preceding claim, comprising a single photodetector (PD, PD1, PD2) coupled to a waveguide (WG; WG1, WG2) downstream of the filter.

12. The photonic system (1) according to claim 10 or 11, further comprising an input photodetector (PDin; PDin1, PDin2) coupled to the waveguide (WG; WG1, WG2) upstream of the filter (MR; MR1, MR2, MR3).

13. The photonic system (1) according to any of claims 10 to 12, wherein the photonic device is a tunable laser.

14. The photonic system (1) according to any of claims 10 to 12, wherein the photonic device is an optical router.

15. The photonic system (1) according to any of claims 10 to 12, wherein the laser source comprises a plurality of lasers (La1, La2, La3) emitting a plurality of emission frequencies.

16. The photonic system (1) according to the preceding claim, wherein adjustment devices (H) associated with the lasers (La1, La2, La3) of the source are controlled to modulate the emission frequencies of the source and at least one adjustment device (H) associated with the filter (MR; MR1, MR2, MR3) is controlled to adjust the resonant frequency of the filter (MR; MR1, MR2, MR3).
